(19) **Europäisches Patentamt**
European Patent Office
Office européen des brevets

(11) **EP 3 323 667 B1**

(12) **EUROPÄISCHE PATENTSCHRIFT**

(45) Veröffentlichungstag und Bekanntmachung des Hinweises auf die Patenterteilung:
**19.08.2020 Patentblatt 2020/34**

(21) Anmeldenummer: **17199702.6**

(22) Anmeldetag: **02.11.2017**

(51) Int Cl.:
*B60L 3/00* (2019.01)　　　　*G01R 31/36* (2020.01)
*H01M 10/44* (2006.01)　　　*H02J 7/00* (2006.01)
*B60L 3/12* (2006.01)　　　　*B60L 3/04* (2006.01)
*H01M 10/42* (2006.01)

(54) **TRAKTIONSENERGIESPEICHERSYSTEM MIT BETRIEBSGRENZENBESTIMMUNG**

TRACTION ENERGY STORAGE SYSTEM WITH IDENTIFICATION OF OPERATING LIMITS

SYSTÈME DE STOCKAGE D'ÉNERGIE DE TRACTION À LIMITATION DE FONCTIONNEMENT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **17.11.2016 DE 102016013702**

(43) Veröffentlichungstag der Anmeldung:
**23.05.2018 Patentblatt 2018/21**

(73) Patentinhaber: **MAN Truck & Bus SE**
**80995 München (DE)**

(72) Erfinder: **Kratzer, Sebastian**
**80997 München (DE)**

(74) Vertreter: **v. Bezold & Partner Patentanwälte - PartG mbB**
**Akademiestraße 7**
**80799 München (DE)**

(56) Entgegenhaltungen:
**EP-A1- 2 541 641　　　EP-A1- 2 560 265**
**EP-A1- 2 712 046　　　EP-A1- 2 993 724**
**EP-A1- 3 273 507　　　EP-A1- 3 309 003**
**EP-A2- 3 244 477　　　DE-A1-102012 202 079**
**DE-A1-102013 000 907　DE-A1-102014 223 278**
**US-A1- 2007 080 662**

**Beschreibung**

Die Erfindung betrifft ein Traktionsenergiespeichersystem für ein Fahrzeug, beispielsweise für ein Nutzfahrzeug. Insbesondere betrifft die Technik ein Traktionsenergiespeichersystem, das veränderliche Betriebsgrenzen berücksichtigt.

Die zumindest teilweise Elektrifizierung des Antriebsstrangs eines Fahrzeugs ist kostenintensiv. Zu den Kosten tragen die Entwicklung und die Erprobung des Energiespeichers wesentlich bei. Durch die Zahl verschiedener Anwendungsfälle und den damit verbundenen Entwicklungs- und Erprobungsaufwand vervielfachen sich die Kosten. Die Zahl der Anwendungsfälle ist durch mehrere Faktoren bestimmt. Zum einen besteht oftmals der Wunsch, eine möglichst große Anzahl von Fahrzeugderivaten zu elektrifizieren. Zum anderen besteht bei jedem Fahrzeugderivat regelmäßig Bedarf nach unterschiedlichen Elektrifizierungsgraden, beispielsweise einem Batterie-Elektrofahrzeug (BEV), einem Plug-in-Hybridfahrzeug (PHEV) und einem Hybrid-Elektrofahrzeug (HEV).

Das Dokument DE 10 2010 002 939 A1 beschreibt einen herkömmlichen Energiespeicher. Der Energiespeicher umfasst eine Vielzahl einzelner Speicherzellen, wobei Gruppen von Speicherzellen jeweils zu einem Speichermodul und die Speichermodule zum Energiespeicher verschaltet sind.

Das Dokument US 2007/0080662 A1 beschreibt einen weiteren herkömmlichen Energiespeicher, der über die Leistungsverschaltung hinaus einen Datenbus aufweist. Der Datenbus verbindet Modulsteuerungen an den einzelnen Zellmodulen mit einer Steuerung des Energiespeichers.

Das Dokument DE 10 2007 038 532 A1 beschreibt einen als Batteriepack bezeichneten Energiespeicher mit mehreren miteinander verbundenen Zellen, die jeweils eine Spannung bereitstellen. Einer oder mehreren Zellen ist eine Überwachungsschaltung zugeordnet. Eine Kopplungsanordnung stellt auf Grundlage der Überwachungsschaltungen ein von den Zellen galvanisch getrenntes Zustandssignal bereit.

Um der Vielzahl verschiedener Anwendungsfälle gerecht zu werden, muss der herkömmliche Energiespeicher hinsichtlich der Anzahl seiner Zellmodule, der Steuerung des Energiespeichers und seiner Eigensicherheit für jeden Anwendungsfall entwickelt und erprobt werden. Wachsende Anforderungen an die gespeicherte Traktionsenergie, insbesondere für Nutzfahrzeuge, erfordern eine größere Anzahl an Speicherzellen. Aufgrund unterschiedlicher Einflussfaktoren wie Temperatur, Fertigungsstreuung, Selbstentladung, Alterung, etc. driften im Laufe der Nutzung elektrische Eigenschaften der Speicherzellen auseinander. Da jedoch möglichst viele Speicherzellen direkt oder indirekt elektrisch miteinander verbunden sind, ist eine individuelle Strom- und/oder Leistungsregelung pro System nicht möglich.

Somit ist eine Aufgabe der Erfindung, eine Technik zur Speicherung von Traktionsenergie mittels einer fahrzeugangepassten Anzahl an Speicherzellen bereitzustellen, die während der Nutzung die Betriebsbedingungen der Speicherzellen berücksichtigt.

Diese Aufgabe wird durch ein Traktionsenergiespeichersystem für ein Fahrzeug mit den Merkmalen des Anspruchs 1 gelöst.

Gemäß einem Aspekt umfasst ein Traktionsenergiespeichersystem (TES-System) mehrere elektrische Energiespeicher (TES). Jeder der TES umfasst ein oder mehrere über Stromschienen elektrisch verbundene Zellmodule, eine mit den Stromschienen verbundene oder verbindbare Energiespeicherhochvoltschnittstelle (TES-Hochvoltschnittstelle) und eine die Zellmodule steuernde Energiespeichersteuerung (TES-Steuerung). Jedes der Zellmodule umfasst mehrere Speicherzellen und eine Zellmodulsteuerung. Jede der Zellmodulsteuerungen ist dazu ausgebildet, die Speicherzellen im jeweiligen Zellmodul betreffende Messwerte an die TES-Steuerung auszugeben. Jede der TES-Steuerungen ist dazu ausgebildet, abhängig von den erhaltenen Messwerten ein Signal oder Signale mit elektrischen Kenngrößen des jeweiligen TES und mindestens einem Grenzwert für einen Strom durch die TES-Hochvoltschnittstelle des jeweiligen TES zu erzeugen. Das TES-System umfasst ferner eine Systemsteuerung, die dazu ausgebildet ist, die Signale von den TES-Steuerungen zu erhalten, auf Grundlage der Kenngrößen aller TES den Strom durch jede der TES-Hochvoltschnittstellen bei Parallelschaltung der TES-Hochvoltschnittstellen zu berechnen, und auf Grundlage der berechneten Ströme und der Grenzwerte für die Ströme einen Systemgrenzwert für die Summe der Ströme zu bestimmen und als Systemsignal auszugeben.

Die Kenngrößen der TES können jeweils einen Ladezustand (auch: "State of Charge" oder SoC), einen Innenwiderstand und/oder eine Leerlaufspannung (auch: "Open-Circuit Voltage" oder OCV) des jeweiligen TES umfassen. Die Kenngrößen des jeweiligen TES können den Innenwiderstand und die Leerlaufspannung des jeweiligen TES angeben oder von der Leerlaufspannung und dem Innenwiderstand des jeweiligen TES abhängen.

Die Messwerte der Speicherzellen und/oder der Zellmodule können jeweils einen Ladezustand, einen Innenwiderstand und/oder eine Leerlaufspannung der Speicherzelle bzw. des Zellmoduls angeben. Jede TES-Steuerung kann auf Grundlage der Messwerte im jeweiligen TES die Kenngrößen berechnen.

Die Summe der Ströme wird auch als Systemstrom bezeichnet. Die einheitliche Spannung der parallelgeschalteten TES-Hochvoltschnittstellen wird auch als Systemspannung bezeichnet.

Die Grenzwerte der TES und/oder die Systemgrenzwerte des TES-Systems können jeweils einen Strom und/oder eine Spannung angeben. Die TES-Grenzwerte und/oder die Systemgrenzwerte können jeweils eine obere Grenze und/oder untere Grenze angeben. Die TES-Grenzwerte und/oder die Systemgrenzwerte können jeweils einen Wert für einen entladenden Betriebsmodus und einen Wert für einen ladenden Betriebsmodus angeben.

Der Systemgrenzwert für den Systemstrom und/oder weitere Systemgrenzwerte (beispielsweise für die Systemspannung) zum Betrieb des TES-Systems werden auch als Systembetriebsgrenzen bezeichnet. Die Grenzwerte für die Ströme der TES und/oder weitere Grenzwerte (beispielsweise für die Spannungen der TES) zum Betrieb der TES werden auch als TES-Betriebsgrenzen bezeichnet. Die Systembetriebsgrenzen und/oder die TES-Betriebsgrenzen können jeweils einen Ladestrom, einen Entladestrom, eine Ladespannung, eine Entladespannung, eine Ladeleistungen und/oder eine Entladeleistung des TES-Systems bzw. des jeweiligen TES umfassen, beispielsweise ein Maximum und/oder ein Minimum einer oder mehrerer dieser Größen.

Das TES-System kann auch als TES-System oder, um die Mehrzahl umfasster TES zu betonen, als Multi-TES-System bezeichnet werden. Das TES-System kann aufgrund der Mehrzahl der TES modular und/oder skalierbar sein. Durch die Mehrzahl der TES kann das TES-System eine fahrzeugangepasste Speicherkapazität aufweisen.

Eine Verteilung elektrischer Eigenschaften und/oder chemischer Zustände der Vielzahl an Speicherzellen kann sich während der Nutzung verbreitern, beispielsweise aufgrund unterschiedlicher Umgebungstemperaturen, Fertigungsstreuung, Selbstentladung und/oder Alterung. Dadurch können sich die Kenngrößen der TES unterscheiden und/oder verändern.

Die Technik ermöglicht eine dynamische Bestimmung (beispielsweise eine auf die Gegenwart bezogene Schätzung und/oder eine auf einen zukünftigen Zeitraum bezogene Prognose) einer oder mehrerer Systembetriebsgrenzen. Die Systemsteuerung kann dazu ausgebildet sein, die Systembetriebsgrenzen zur Laufzeit zu berechnen. Die Systembetriebsgrenzen können für einen Prognosezeitraum bestimmt werden, beispielsweise auf Grundlage der für den Prognosezeitraum erhaltenen TES-Betriebsgrenzen. Der Prognosezeitraum kann z. B. die nächsten 10 Sekunden umfassen.

Optional ist die Systemsteuerung dazu ausgebildet, die bestimmten Systembetriebsgrenzen (beispielsweise den Systemgrenzwert für den Systemstrom und/oder die Systemspannung) an das Fahrzeug auszugeben. Die Systemsteuerung kann ferner dazu ausgebildet sein, periodisch die Systembetriebsgrenzen zu bestimmen und/oder auszugeben.

Die bestimmten Systembetriebsgrenzen können von einer Kombination der TES-Betriebsgrenzen abhängen. Die bestimmten Systembetriebsgrenzen können direkt oder indirekt von Temperatur, Nutzungszeit und/oder Ladezustand der TES abhängen.

Jede Zellmodulsteuerung kann einen aus dem Stand der Technik bekannten Funktionsumfang umfassen. Jede TES-Steuerung kann einen aus dem Stand der Technik bekannten Funktionsumfang (auch: Slave-Funktionsumfang) umfassen. Die Systemsteuerung kann einen darüber hinausgehenden Funktionsumfang (auch: Master-Funktionsumfang) aufweisen, der beispielsweise die TES untereinander koordiniert und/oder die Systemgrenzwerte berechnet. Die Berechnung der einzelnen TES-Ströme, die Bestimmung der Systemgrenzwerte und/oder die Ausgabe der Systemgrenzwerte oder eines anderen Systemsignals kann Teil des Master-Funktionsumfangs sein.

Das TES-System kann mindestens zwei parallel verschaltete TES umfassen. Jeder TES kann mehrere parallel und/oder seriell miteinander verschaltete Speicherzellen umfassen.

Eine gewisse Anzahl von Speicherzellen kann mit einer der Zellmodulsteuerungen zu jeweils einem der Zellmodule zusammengefasst sein. Die Zellmodule innerhalb jedes TES können in Reihe oder parallelgeschaltet sein.

Mindestens ein Zellmodul in jedem TES steht in Signalaustausch mit der jeweiligen TES-Steuerung. Der Signalaustausch kann eine logische Verbindung sein.

Die Systemsteuerung kann ferner dazu ausgebildet sein, eine Abweichung zwischen den Kenngrößen der TES zu bestimmen. Die Abweichung kann eine Varianz der Kenngrößen und/oder eine Differenz zwischen Minimum und Maximum der Kenngrößen aller TES umfassen. Die Systemsteuerung kann die Systemgrenzwerte bestimmen und/oder ausgeben in Reaktion auf ein Überschreiten eines Schwellwerts der Abweichung.

Alternativ oder ergänzend können die Kenngrößen auf Anfrage der Systemsteuerung bestimmt werden. Die Systemsteuerung kann ferner dazu ausgebildet sein, Fahrzeuganweisungen vom Fahrzeug zu erhalten. Eine Steueranweisung des Fahrzeugs kann das Bestimmen und/oder das Ausgeben der Systemgrenzwerte bewirken. Jede TES-Steuerung kann ferner dazu ausgebildet sein, auf die Anfrage der Systemsteuerung die Messwerte abzufragen.

Das Berechnen der Ströme durch die parallelgeschalteten Energiespeicherhochvoltschnittstellen kann die Ströme als Funktion des Systemstroms und/oder der Systemspannung Summe bestimmen. Die Kenngrößen können Parameter dieser Funktion sein.

Die Systemsteuerung kann dazu ausgebildet sein, den oder die Systemgrenzwerte für den Systemstrom durch Maximieren und/oder Minimieren des Systemstroms unter Einhaltung der Grenzwerte aller TES zu bestimmen. Alternativ oder ergänzend kann die Systemsteuerung dazu ausgebildet sein, den oder die Systemgrenzwerte für den Systemstrom zu bestimmen durch Bestimmen eines begrenzenden (auch: limitierenden) Grenzwerts unter den Grenzwerten aller TES, welcher den Systemstrom als Funktion der Ströme der TES begrenzt.

Die Systemsteuerung kann ferner dazu ausgebildet sein, auf Grundlage der berechneten Ströme der TES und der Grenzwerte für die Ströme einen Systemgrenzwert für die Systemspannung zu bestimmen. Alternativ oder ergänzend kann die Systemsteuerung dazu ausgebildet sein, den Systemgrenzwert für die Systemspannung auf Basis des Systemgrenzwerts für den Systemstrom zu bestimmen. Optional gibt die Systemsteuerung den Systemgrenzwert der Systemspannung als Systemsignal aus, beispielsweise zusammen mit dem Systemgrenzwert des Systemstroms.

Die Ströme durch die parallelgeschalteten TES-Hochvoltschnittstellen können berechnet werden als Funktion der Systemspannung. Die Systemsteuerung kann dazu ausgebildet sein, den oder die Systemgrenzwerte für die Spannung zu bestimmen durch Maximieren und/oder Minimieren der Systemspannung unter Einhaltung der Grenzwerte aller TES.

Die TES können die Grenzwerte jeweils für das Laden und für das Entladen des jeweiligen TES erzeugen. Die Systemsteuerung kann den oder die Systemgrenzwerte jeweils für das Laden und für das Entladen des TES-Systems bestimmen und/oder ausgeben.

Die Kenngrößen und/oder die Grenzwerte der TES können zeitabhängig sein, beispielsweise als eine Funktion der Zeit oder eine entsprechende Liste zeitabhängiger Werte. Die Kenngrößen und/oder die Grenzwerte der TES können mit einem Prognosezeitraum assoziiert sein. Der oder die Systemgrenzwerte können als Funktion der Zeit oder eine entsprechende Liste zeitabhängiger Werte bestimmt und/oder ausgegeben werden. Der oder die Systemgrenzwerte können mit dem Prognosezeitraum assoziiert sein. Den erhaltenen Grenzwerten der TES und/oder der Berechnung der Systemsteuerung können kontinuierliche, optional konstante, Ströme innerhalb des Prognosezeitraums zugrunde liegen.

Jeder TES kann mindestens ein Schaltschütz umfassen. Die TES-Steuerung kann das Schaltschütz oder die Schaltschütze steuern. In jedem TES kann das Schaltschütz oder können die Schaltschütze dazu ausgebildet sein, die Stromschienen des TES mit der TES-Hochvoltschnittstelle des jeweiligen TES nach Vorgabe der TES-Steuerung in einer Schließstellung des Schaltschützes zu verbinden und in einer Offenstellung des Schaltschützes zu trennen. Beispielsweise können zwei Schaltschütze jeweils einen Pol der Stromschienen mit der TES-Hochvoltschnittstelle verbinden und trennen.

Die TES-Hochvoltschnittstellen (einzelner TES oder in Clustern seriell geschalteter TES) können im TES-System parallelgeschaltet sein. Die Systemsteuerung kann dazu ausgebildet sein, die Schließstellung der Schaltschütze aller TES oder einer Teilmenge der TES in einem Betriebszustand des TES-Systems zu bewirken und/oder die Offenstellung der Schaltschütze aller TES in einem Ruhezustand des TES-Systems zu bewirken. Der Betriebszustand kann den entladenden Betriebsmodus und/oder den ladenden Betriebsmodus umfassen.

Das Schaltschütz kann dazu ausgebildet sein, die TES-Hochvoltschnittstelle des TES in der Schließstellung mit den untereinander verschalteten Zellmodulen zu verbinden und in der Offenstellung von diesen zu trennen. Die Stromschienen jedes TES können jeweils eine Minusschiene und eine gegenüber der Minusschiene potentialhöhere Plusschiene umfassen. Die TES-Hochvoltschnittstellen können jeweils einen Minuspol und einen Pluspol umfassen. Die Stromschienen können in der Schließstellung mit der TES-Hochvoltschnittstelle verbunden sein, indem die Plusschiene und die Minusschiene mit dem Pluspol bzw. dem Minuspol verbunden sind. Die Stromschienen können in der Offenstellung von der TES-Hochvoltschnittstelle getrennt sein, indem die Plusschiene vom Pluspol getrennt ist, beispielsweise bei mit dem Minuspol verbundener Minusschiene.

Die parallelgeschalteten TES-Hochvoltschnittstellen können ferner zum Energieaustausch mit dem Fahrzeug verbunden sein. Ein Leistungsnetz (beispielsweise eine Hochvoltverteilungseinheit) des Fahrzeugs kann mit den parallelgeschalteten TES-Hochvoltschnittstellen verbunden sein. Der Energieaustausch kann auf den Betriebszustand beschränkt sein. Ein Stromfluss zwischen TES-System und dem Fahrzeug (beispielsweise einem Umwandler oder Inverter des Fahrzeugs) kann im Ruhezustand unterbrochen sein.

Das TES-System kann ferner eine Systemhochvoltschnittstelle und/oder ein Systemschaltschütz umfassen. Die Systemhochvoltschnittstelle ist mit dem Fahrzeug elektrisch verbunden oder verbindbar, beispielsweise mit einem Antriebsstrang des Fahrzeugs. Das Systemschaltschütz ist dazu ausgebildet, die parallelgeschalteten TES-Hochvoltschnittstellen mit der Systemhochvoltschnittstelle nach Vorgabe der Systemsteuerung (in einer Schließstellung des Systemschaltschützes) zu verbinden und (in einer Offenstellung des Systemschaltschützes) zu trennen. Die Systemsteuerung kann die Schließstellung des Systemschaltschützes im Betriebszustand bewirken. Die Systemsteuerung kann ferner dazu ausgebildet sein, im Ruhezustand die Offenstellung des Systemschaltschützes zu bewirken.

Jede der Zellmodulsteuerungen kann dazu ausgebildet sein, die Speicherzellen im jeweiligen Zellmodul betreffende Messwerte auszugeben. Jede der TES-Steuerungen kann dazu ausgebildet sein, die Messwerte von den Zellmodulen im jeweiligen TES zu erhalten und abhängig von den erhaltenen Messwerten das Signal zu erzeugen. Die von den TES-Steuerungen ausgegebenen Kenngrößen und Grenzwerte werden kollektiv als Speicherzustand des jeweiligen TES bezeichnet.

Eine der TES-Steuerungen kann die Funktion der Systemsteuerung ausführen. Diese eine TES-Steuerung kann auch als Master-TES-Steuerung bezeichnet werden. Jede weitere TES-Steuerung des TES-Systems kann auch als Slave-TES-Steuerung bezeichnet werden.

Die Funktion der Systemsteuerung kann in jeder der TES-Steuerungen implementiert sein und in einer der TES-Steuerungen zur Ausführung aktiviert sein. Die Funktion der Systemsteuerung kann in nur einer der TES-Steuerungen zur Ausführung aktiviert sein. In allen anderen TES-Steuerungen kann die Funktion der Systemsteuerung deaktiviert sein. Jede der TES-Steuerungen kann dazu ausgebildet sein, in einem ersten Energiespeicherbetriebszustand die Funktion auszuführen und in einem zweiten Energiespeicherbetriebszustand die Funktion nicht auszuführen.

Jeder der TES kann ferner eine erste Datenschnittstelle und/oder eine von der ersten Datenschnittstelle verschiedene zweite Datenschnittstelle umfassen. Die Datenschnittstellen (oder eine Teilmenge derer) können innerhalb des TES mit der TES-Steuerung verbunden sein.

Bei jenen TES, welche nicht die Funktion der Systemsteuerung ausführen, kann die erste Datenschnittstelle außerhalb des TES unverbunden sein oder entfallen. Alternativ oder ergänzend kann bei jenen TES die zweite Datenschnittstelle zur Ausgabe des Signals mit der zweiten Datenschnittstelle des TES verbunden sein, welcher die Funktion der Systemsteuerung ausführt.

Bei jenem TES, welcher die Funktion der Systemsteuerung ausführt, kann die erste Datenschnittstelle außerhalb des TES mit dem Fahrzeug verbunden sein zur Ausgabe des Systemgrenzwerts oder eines anderen Systemsignals. Alternativ oder ergänzend kann die zweite Datenschnittstelle jenes TES zum Erhalt der Signale mit den zweiten Datenschnittstellen der TES verbunden sein, welche nicht die Funktion der Systemsteuerung ausführen. Die zweiten Datenschnittstellen aller TES können an einen gemeinsamen Datenbus angeschlossen sein.

Die Systemsteuerung kann dazu ausgebildet sein, die erhaltenen Signale zum Systemsignal zu aggregieren und das aggregierte Systemsignal auszugeben, z. B. im Betriebszustand des TES-Systems. Die Aggregation der mehreren Signale zu einem Systemsignal durch die Systemsteuerung kann eine einheitliche Signalausgabe (oder Kommunikation) gegenüber dem Fahrzeug ermöglichen. Beispielsweise können verschiedene Fahrzeugderivate und/oder Fahrzeuge mit unterschiedlichen Elektrifizierungsgraden des Antriebsstrangs eine einheitliche Kommunikationsschnittstelle zum TES-System nutzen.

Ein Aufbau der fahrzeugseitigen Kommunikationsschnittstelle und ein Protokoll der fahrzeugseitigen Kommunikation des TES-Systems können für verschiedene Anwendungsfälle gleich sein. Die Anwendungsfälle können sich hinsichtlich Anzahl und Verschaltung der TES unterscheiden. Die Anzahl und die Verschaltung der TES kann an einen Energie- und Leistungsbedarf des Fahrzeugs angepasst werden, ohne die fahrzeugseitige Kommunikation anzupassen.

Das hierarchisch strukturierte TES-System mit den TES auf einer Hierarchieebene und den Zellmodulen auf einer darunterliegenden Hierarchieebene kann einen Bestimmung der Systemgrenzwerte für das TES-System ermöglichen, deren Dauer (beispielsweise einschließlich Messung) nicht oder nicht linear mit der Anzahl der Speicherzellen oder der Zellmodule zunimmt. Beispielsweise kann jede TES-Steuerung dazu ausgebildet sein parallel, auf Grundlage der von den Zellmodulsteuerungen erhaltenen Messwerte, die Kenngrößen zu bestimmen.

Falls die Kenngrößen eines TES um mehr als einen Schwellwert (beispielsweise absolut oder prozentual) abweichen gegenüber den Kenngrößen der anderen TES (oder einem Mittelwert der Kenngrößen), kann die Systemsteuerung diesen TES (beispielsweise durch die Offenstellung des entsprechenden Schaltschützes) von der Parallelschaltung ausnehmen. Der Ausschluss des TES kann in einer Fehlermeldung oder Diagnosemeldung an das Fahrzeug ausgegeben werden. Beispielsweise kann einer der TES als fehlerhaften oder gealtert angegeben sein. Ferner kann die Diagnosemeldung aufgrund zellmodul-spezifischer Messwerte ein einzelnes Zellmodul (beispielsweise als fehlerhaft oder gealtert) angeben.

Dies ist beispielsweise vorteilhaft, falls der Systemgrenzwert des TES-Systems vom leistungsschwächsten TES oder Zellmodul abhängt. Durch einen gezielten Austausch des angegebenen TES oder Zellmoduls kann die Leistungsfähigkeit des TES-System zeit- und kosteneffektiv wiederhergestellt werden.

Die TES-Steuerung jedes TES kann mit den jeweiligen Zellmodulsteuerungen desselben TES zum Datenaustausch verbunden sein, beispielsweise über einen seriellen Datenbus. Die Messwerte können eine Spannung (z. B., eine Modulspannung aller Speicherzellen) und/oder eine Temperatur (z. B. eine Modultemperatur, einen Temperaturmittelwert oder ein Temperaturmaximum) der Zellmodule angeben.

Jede Zellmodulsteuerung kann dazu ausgebildet sein, die Messwerte zu erfassen und/oder an die jeweils verbundene TES-Steuerung auszugeben. Die Zellmodulsteuerung kann an zumindest einer der jeweiligen Speicherzellen angrenzend oder anliegend angeordnet sein. Sensoren zur Erfassung der Messwerte können in der Zellmodulsteuerung angeordnet sein.

Die Signale und/oder das Systemsignal können die Messwerte, einen Zustandswert oder einen Diagnosewert angeben. Das Aggregieren der Signale zum Systemsignal kann eine Mittelwertbildung, eine Minimumbestimmung und/oder eine Maximumbestimmung umfassen. Die Systemsteuerung kann zur bidirektionalen Kommunikation mit dem Fahrzeug ausgebildet sein. Die Systemsteuerung kann dazu ausgebildet sein, ein Fahrzeugsignal zu erhalten. Die Systemsteuerung kann das Fahrzeugsignal analysieren und abhängig von der Analyse ein Steuersignal an mindestens eine der TES-Steuerungen ausgeben. Das Fahrzeugsignal kann eine Steuerungsanweisung (z. B. die Fahrzeuganweisung) und/oder eine Zustandsabfrage umfassen.

Die Systemsteuerung kann dazu ausgebildet sein, über die erste Datenschnittstelle ein Notabschaltsignal vom Fahrzeug zu erhalten. Die Systemsteuerung kann ferner dazu ausgebildet sein, beim Erhalt des Notabschaltsignals ein Steuersignal zur Trennung der Schaltschütze an die TES-Steuerungen zu senden.

Das aggregierte Systemsignal kann einen Systemzustand des TES-Systems angeben. Ein Datenformat zur Angabe des Zustands, eine physikalische Definition der jeweils genutzten Datenschnittstelle und/oder ein Kommunikationsprotokoll kann für die Signale und das aggregierte Systemsignal übereinstimmend sein.

Der Speicherzustand und der Systemzustand können einen gegenwärtigen Zustand des jeweiligen TES bzw. des TES-Systems angeben. Alternativ oder ergänzend können der Speicherzustand und der Systemzustand eine (z. B. prognostizierte) Leistungsfähigkeit des jeweiligen TES bzw. des TES-Systems angeben. Die Signale der TES-Steuerungen können einen gegenwärtigen Ladezustand und/oder einen (z. B. zukünftig entnehmbaren) Maximalstrom des jeweiligen TES angeben. Der Ladezustand kann, beispielsweise mittels einer tabellierten Ladekurve, aus der gemessenen Spannung (z. B. der Leerlaufspannung) bestimmt werden. Der entnehmbare Maximalstrom kann, beispielsweise mittels einer tabellierten Funktion, aus dem Ladezustand und/oder der gemessenen Temperatur bestimmt werden. Jede die Funktion der Systemsteuerung nicht ausführende TES-Steuerung kann ein eigenes Signal (z. B. mit einem eigenen Datensatz und/oder mittels eines eigenen Datagramms) an die die Funktion der Systemsteuerung ausführende TES-Steuerung ausgeben.

Die TES-Steuerungen können jeweils dazu ausgebildet sein, den Speicherzustand des jeweiligen TES festzustellen, beispielsweise auf Grundlage der von den Zellmodulen erhaltenen Messwerte und/oder weiterer Messwerten der TES-Steuerung. Die TES-Steuerung kann ferner dazu ausgebildet sein, bei Feststellung eines unzulässigen Speicherzustands das jeweilige Schaltschütz oder die jeweiligen Schaltschütze zu trennen und/oder eine Fehlermeldung als das Signal zu erzeugen und an die Systemsteuerung auszugeben. Das Signal der betreffenden TES-Steuerung kann den unzulässigen Speicherzustand benennen und/oder die Unzulässigkeit als solche angeben.

Die Feststellung des Speicherzustands kann ein Messen des durch den jeweiligen TES abgegebenen Stroms umfassen. Der unzulässige Speicherzustand kann bei Überschreiten des entnehmbaren Maximalstroms festgestellt werden. Alternativ oder ergänzend können die Signale jeweils den entnehmbaren Maximalstrom des jeweiligen TES als einen der Grenzwerte angeben.

Das aggregierte Systemsignal kann den oder die Systemgrenzwerte umfassen. Optional werden der oder die Systemgrenzwerte unter Ausschluss jener TES bestimmt, für die ein unzulässiger Speicherzustand festgestellt oder signalisiert ist.

Die Feststellung des Zustands kann ein Bestimmen des Ladezustands des jeweiligen TES oder einer dem jeweiligen TES entnehmbare Ladung umfassen. Der unzulässige Speicherzustand kann bei Unterschreiten einer Mindestladung festgestellt werden. Die erzeugten Signale können jeweils den Ladezustand oder die entnehmbare Ladung des jeweiligen TES angeben. Der Systemzustand kann die Summe der signalisierten entnehmbaren Ladungen angeben.

Die entnehmbare Ladung kann durch zeitliche Integration des Stroms bestimmt werden. Alternativ oder ergänzend kann die entnehmbare Ladung aufgrund der gemessenen Spannung mittels einer tabellierten Funktion bestimmt werden.

Jeder TES kann einen Schutzleiterkontakt umfassen. Der Schutzleiterkontakt kann mit einer Karosserie des Fahrzeugs verbunden oder verbindbar sein. Die Feststellung des Zustands kann ein Messen des Isolationswiderstands zwischen einem Pol (oder beiden Polen) der TES-Hochvoltschnittstelle und dem Schutzleiterkontakt des jeweiligen TES umfassen. Der unzulässige Speicherzustand kann bei Unterschreiten eines Isolationswiderstandswerts festgestellt werden.

Jeder der TES kann in einem eigenen Gehäuse angeordnet sein. In einer oder mehreren Außenflächen des Gehäuses kann mindestens eines der folgenden Merkmale angeordnet sein: die erste Datenschnittstelle, die zweite Datenschnittstelle, die TES-Hochvoltschnittstelle und der Schutzleiterkontakt.

Gemäß weiteren Aspekten sind ein Fahrzeug, beispielsweise ein Nutzfahrzeug, mit einem solchen TES-System, sowie ein Verfahren zur Herstellung eines Fahrzeugs mit einem Schritt des Bestimmens der Anzahl an Energiespeichern für das Fahrzeug und einem Schritt des Einbaus des fahrzeugspezifischen TES-Systems bereitgestellt.

Vorstehend beschriebene Merkmale sind in jeder Kombination realisierbar. Weitere Merkmale und Vorteile der Erfindung werden im Folgenden unter Bezugnahme auf die beigefügten Zeichnungen beschrieben. Es zeigen:

Figur 1    ein schematisches Blockschaltbild eines ersten Ausführungsbeispiels eines Traktionsenergiespeichersystems für ein Fahrzeug;

Figur 2    ein schematisches Blockschaltbild eines zweiten Ausführungsbeispiels eines Traktionsenergiespeichersystems für ein Fahrzeug;

Figur 3    ein schematisches Blockschaltbild eines dritten Ausführungsbeispiels eines Traktionsenergiespeichersystems für ein Fahrzeug;

Figur 4    ein funktionales Blockdiagramm einer beispielhaften Signalverarbeitung im Traktionsenergiespeichersystem, die in den Ausführungsbeispielen der Figuren 1 bis 3 implementierbar ist;

Figur 5    ein Ablaufdiagramm eines Verfahrens zum Bestimmen von Betriebsgrenzen des Traktionsenergiespeichersystems für ein Fahrzeug;

Figur 6    einen ersten Aspekt einer Implementierung des Verfahrens der Figur 5; und

Figur 7    einen zweiten Aspekt einer Implementierung des Verfahrens der Figur 5.

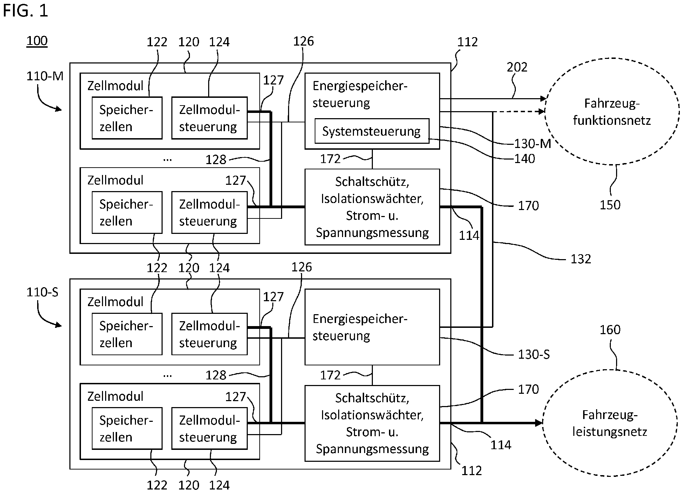

Figur 1 zeigt ein schematisches Blockschaltbild eines allgemein mit Bezugszeichen 100 bezeichneten Traktionsenergiespeichersystems (TES-Systems) für ein Fahrzeug, beispielsweise ein Nutzfahrzeug. Das TES-System 100 umfasst mindestens zwei Energiespeicher 110 (auch: Traktionsenergiespeicher oder TES). Jeder TES 110 umfasst jeweils mehrere Zellmodule 120 und eine Energiespeichersteuerung 130 (auch: Traktionsenergiespeicher-Steuerung oder TES-Steuerung).

Jedes der Zellmodule 120 umfasst mehrere Speicherzellen 122 und eine Zellmodulsteuerung 124. Jede Zellmodulsteuerung 124 erfasst Messwerte betreffend die jeweils zugeordneten Speicherzellen 122. Zum Beispiel erfasst die Zellmodulsteuerung 124 eine Spannung und/oder eine Temperatur der Speicherzellen 122 im jeweiligen Zellmodul 120. Jede der Zellmodulsteuerungen 124 ist dazu ausgebildet, die Messwerte auf einem internen Datenbus 126 auszugeben. Der interne Datenbus 126 des Zellmoduls 120 kann ein serieller Bus, beispielsweise für ein Controller Area Network (CAN), sein.

Jede der TES-Steuerungen 130 ist dazu ausgebildet, die Messwerte von den Zellmodulen 120 im jeweiligen TES 110 zu erhalten. Hierzu ist jede TES-Steuerung 130 mit dem jeweiligen internen Datenbus 126 verbunden.

Jede der TES-Steuerungen 130 ist ferner dazu ausgebildet, abhängig von den erhaltenen Messwerten ein Signal zu erzeugen. Zur Ausgabe des Signals oder anderer Signale ist die TES-Steuerung 130 mit einem externen Datenbus 132 verbunden. Der externe Datenbus 132 des TES-Systems 100 kann ein serieller Bus sein, beispielsweise ein weiterer CAN-Bus. Der externen Datenbus 132 kann ausschließlich zur Kommunikation zwischen den TES 110 (bzw. deren TES-Steuerungen 130) ausgebildet sein.

Die TES 110 sind jeweils in einem eigenen Gehäuse 112 angeordnet. Der interne Datenbus 126 verläuft innerhalb des jeweiligen Gehäuses 112. Der externe Datenbus 132 verläuft au-βerhalb der Gehäuse 112.

Das TES-System 100 umfasst ferner eine Systemsteuerung 140, die Signale von den TES-Steuerungen 130 erhält. Die Signale von den TES-Systemsteuerungen 130 können elektrische Kenngrößen des jeweiligen TES 110 umfassen. Auf Grundlage der erhaltenen Signale erzeugt die Systemsteuerung 140 ein Systemsignal. Das Systemsignal kann Betriebsgrenzen, beispielsweise Systemgrenzwerte für den Strom und/oder die Spannung, des TES-Systems 100 umfassen. Die Systemsteuerung gibt das Systemsignal an ein Funktionsnetz 150 des Fahrzeugs aus. Das Funktionsnetz 150 kann ein Niederspannungsbordnetz und/oder ein Bussystem zur Kommunikation zwischen Fahrzeugfunktionen umfassen. Das Niederspannungsbordnetz kann eine Versorgungsspannung von 24 Volt bereitstellen.

In einer ersten Variante kann der externe Datenbus 132 ausschließlich zur Kommunikation zwischen den TES 110 (bzw. deren TES-Steuerungen 130) ausgebildet sein. Das Funktionsnetz 150 kann über eine eigene Schnittstelle und/oder eine eigene Busanbindung 202 mit der Systemsteuerung 140 verbunden sein. Hierzu kann ein eigener Bus (beispielsweise ein eigener CAN-Bus) zur Fahrzeugkommunikation vorgesehen sein, der unabhängig vom externen Datenbus 132 arbeitet.

In einer zweiten Variante kann der externe Datenbus 132 (anstelle der separaten Busanbindung 202 oder ergänzend hierzu) mit dem Funktionsnetz 150 verbunden sein (gestrichelter Pfeil).

In beiden Varianten kann das TES-System 100 eine einheitliche Fahrzeugschnittstelle zum Funktionsnetz 150 des Fahrzeugs umfassen, die unabhängig von der Anzahl der eingesetzten und miteinander verbundenen TES 110 ist. Insbesondere bei der ersten Variante kann die Fahrzeugschnittstelle auf eine physischen Ebene (z. B. hinsichtlich Steckverbindung und/oder Signalverlauf) oder einer Bitübertragungsschicht (z. B. hinsichtlich eines Kommunikationsprotokolls) unabhängig von einer veränderlichen Zusammensetzung der vom TES-System 100 umfassten TES 110 sein.

Die Systemsteuerung 140 kann in einem TES 110, beispielsweise in einer der TES-Steuerungen 130, implementiert sein. Alternativ oder ergänzend kann die Systemsteuerung 140 außerhalb der TES 110 implementiert sein, beispielsweise als eine eigene Vorrichtung in einem separaten Gehäuse oder eine Komponente des Funktionsnetzes 150. Ein TES 110, welcher die Funktion der Systemsteuerung 140 ausführt, wird auch als Master-TES 110-M bezeichnet. Der oder die TES 110, welche nicht die Funktion der Systemsteuerung 140 ausführen, werden auch als Slave-TES 110-S bezeichnet. Entsprechende Bezeichnungen gelten für die jeweiligen TES-Steuerungen 130-M bzw. 130-S.

Die Systemsteuerung 140 erhält die Signale von den TES-Steuerungen 130-S über den externen Datenbus 132. Das Systemsignal kann von der Systemsteuerung 140 an das Funktionsnetz 150 über einen direkten Anschluss der Systemsteuerung 140 an das Funktionsnetz 150 ausgegeben werden. Alternativ oder ergänzend, wie im in Figur 1 gezeigten Ausführungsbeispiel, kann das Systemsignal an das Funktionsnetz 150 über den externen Datenbus 132 ausgegeben werden. Hierzu ist das Funktionsnetz 150 (beispielsweise direkt oder über ein Gateway) an den externen Datenbus 132 angeschlossen.

Die Speicherzellen 122 eines Zellmoduls 120 sind (beispielsweise in Reihe) zusammengeschaltet. Die aus der Zusammenschaltung resultierenden Anschlussklemmen 127 sind über Stromschienen 128 verbunden. Die Stromschienen 128 können aus Aluminium oder einem anderen leitenden Material gefertigt sein.

Die aus dem Verbund der Zellmodule 120 jedes TES 110 resultierenden Pole bilden eine TES-Hochvoltschnittstelle 114. Die TES-Hochvoltschnittstellen 114 sind parallel oder in Reihe verschaltet und mit einem Leistungsnetz 160 des Fahrzeugs verbunden oder verbindbar. Das Leistungsnetz 160 kann ein Hochvoltbordnetz des Fahrzeugs umfassen. Ein Antriebsstrang (beispielsweise ein Kurbelwellen-Startergenerator) des Fahrzeugs kann mit dem Leistungsnetz 160 verbunden sein zur Entnahme der im TES-System 100 gespeicherten Energie und/oder zum Laden des TES-Systems 100, beispielsweise bei einem rekuperativen Bremsvorgang. Das Leistungsnetz 160 kann auch als Traktionsnetz bezeichnet werden. Das Leistungsnetz 160 kann eine Spannung von mindestens 60 Volt, beispielsweise zwischen 540 Volt und 738 Volt, bereitstellen. Alternativ oder ergänzend kann das Leistungsnetz 160 jedes Hochvolt-Bordnetz im Sinne des Fahrzeugbaus sein. Eine Topologie des Leistungsnetzes 160 und/oder dessen Komponenten können das Leistungsnetz 160 gegenüber einem Niedervoltnetz (von beispielsweise 24 Volt) abgrenzen. Die Topologie kann einer bekannten Fahrzeugtopologie für Hybrid-, Plug-In- oder Elektrofahrzeuge entsprechen oder angepasst sein. Die Komponenten können einen Umrichter (oder Inverter) für Fahrantriebe, das TES-System 100, eine oder mehrere elektrische Maschinen, Nebenaggregate und/oder einen Kabelbaum umfassen.

Vorzugsweise ist in jedem TES 110 mindestens ein Schaltschütz 170 zwischen den Zellmodulen 120 und dem Leistungsnetz 160 angeordnet. Das Schaltschütz 170 wird beziehungsweise die Schaltschütze 170 werden von der TES-Steuerung 130 im gleichen TES 110 über die mit Bezugszeichen 172 gezeigte Steuerleitung zum wahlweisen Trennen des jeweiligen TES 110 vom Leistungsnetz 160 gesteuert. Das Schaltschütz 170 kann Teil einer Schützbox sein, die ferner die elektrische Isolation der Stromschienen 128 (z. B. gegenüber einem Referenzpotential) überwacht, den über die Stromschienen 128 fließenden Strom misst und/oder die an den Stromschienen 128 anliegende Spannung misst.

In einem Betriebszustand des TES-Systems 100 sind die Schaltschütze 170 aller (funktionsfähigen) TES 110 geschlossen (Schließstellung). Durch Öffnen des Schaltschützes 170 oder der Schaltschütze 170 kann der entsprechende TES 110 im Betriebszustand des TES-Systems 100 aus dem Verbund des TES-Systems 100 isoliert werden, beispielsweise bei einem unzulässigen Speicherzustand. Durch Öffnen des Schaltschützes 170 kann der entsprechende TES 110 von einem Ladungsaustausch ausgeschlossen werden, beispielsweise falls dessen elektrische Kenngrößen um mehr als einen Schwellwert von den elektrischen Kenngrößen der anderen TES 110 abweicht. Vermittels der jeweiligen TES-Steuerung 130 bewirkt die Systemsteuerung 140 im Ruhezustand des TES-Systems 100 die Offenstellung der Schaltschütze 170 aller TES 110.

Weiterhin kann ein Vorladeschaltschütz (oder kurz: Vorladeschütz) und ein mit dem Vorladeschaltschütz in Reihe geschalteter Vorladewiderstand in jedem TES 110 parallel zu einem der Schaltschütze 170 (die auch als Hauptschütze bezeichnet werden können) verbaut sein. Der Vorladewiderstand kann ein Kaltleiter oder PTC-Widerstand (z. B. Positive Temperature Coefficient) sein. Unmittelbar vor der Schließstellung (z. B. für den Betriebszustand) kann die TES-Steuerung 130 den Vorladeschaltschütz schließen. Die TES-Steuerung 130 kann die Schließstellung der Schaltschütze 170 bewirken, sobald einen Spannungsdifferenz am Vorladewiderstand einen Schwellwert unterschreitet.

Die Systemsteuerung 140 ist ferner zur bidirektionalen Kommunikation mit dem Funktionsnetz 150 des Fahrzeugs ausgebildet. Beispielsweise können die Systemsignale in Reaktion auf ein Fahrzeugsignal erzeugt und ausgegeben werden. Ferner kann das Fahrzeugsignal eine Steuerungsanweisung umfassen. Die Systemsteuerung 140 analysiert die Steuerungsanweisung zur Bestimmung derjenigen TES 110, die zur Umsetzung der Steuerungsanweisung relevant sind, und gibt ein Steuersignal an die TES-Steuerungen 130 der betreffenden TES 110 aus.

Das TES-System 100 kann durch den modularen Aufbau auf der Ebene der TES 110 skalierbar eingesetzt werden. Die TES 110 sind mehrfach parallel oder seriell verschaltbar. Durch die Wahl der Verschaltung und der Anzahl verschalteter TES 110 ist das TES-System 100 auf eine Fahrzeug-spezifische Leistungs- und Energieanforderung ausgestaltbar. Diese Anforderungen hängen vom Grad der Elektrifizierung des Antriebsstrangs des Fahrzeugs ab. Ferner kann die Leistungsanforderung durch eine Transportleistung des Fahrzeugs, beispielsweise des Nutzfahrzeugs, und die Energieanforderung durch eine Reichweite des Fahrzeugs bestimmt sein.

Die Systemsteuerung 140 stellt hinsichtlich einer physischen Schnittstelle und eines Kommunikationsprotokolls eine einheitliche Datenschnittstelle zum Fahrzeug bereit, die unabhängig von der Fahrzeug-spezifischen Ausgestaltung des TES-Systems 100 ist. Die mehreren TES 110 verhalten sich aufgrund der Kommunikation über die Systemsteuerung 140 gegenüber dem Fahrzeug wie ein entsprechend großer TES. Dadurch wird ein Fahrzeugspezifischer Integrationsaufwand minimiert.

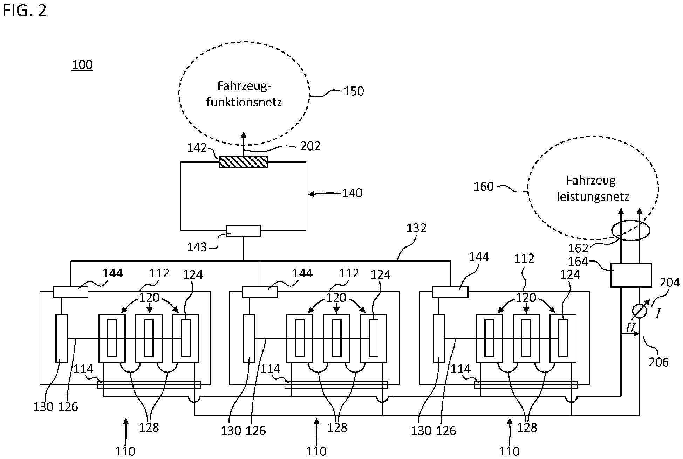

Figur 2 zeigt ein schematisches Blockschaltbild eines zweiten Ausführungsbeispiels eines TES-Systems 100. Mit den anderen Ausführungsbeispielen übereinstimmende Bezugszeichen bezeichnen entsprechende oder identische Merkmale.

Die Systemsteuerung 140 ist außerhalb der Gehäuse 112 der TES 110 angeordnet. Die Systemsteuerung 140 umfasst eine erste Datenschnittstelle 142 für die fahrzeugseitige Kommunikation. Beispielsweise ist die erste Datenschnittstelle 142 mit dem Funktionsnetz 150 und/oder einer Motorsteuerung verbunden. Ferner umfasst die Systemsteuerung 140 eine zweite Datenschnittstelle 143, die über den externen Datenbus 132 mit Datenschnittstellen 144 der TES 110 verbunden ist. Die Systemsteuerung 140 erhält die Signale der einzelnen TES 110 über die zweite Datenschnittstelle 143. Das Systemsignal wird über die erste Datenschnittstelle 142 ausgegeben.

Die TES-Hochvoltschnittstellen 114 der einzelnen TES 110 sind parallel verschaltet und an das Leistungsnetz 160 und/oder einen Wechselrichter (auch: Inverter) des Fahrzeugs angeschlossen. In jedem Ausführungsbeispiel kann eine Systemhochvoltschnittstelle 162 zum Energieaustausch zwischen dem TES-System 100 und dem Leistungsnetz 160 des Fahrzeugs vorgesehen sein. Der Strom *I* durch die Systemhochvoltschnittstelle 162 wird als Systemstrom 204 bezeichnet. Die einheitliche Spannung *U* der Parallelschaltung liegt an der Systemhochvoltschnittstelle 162 an und wird als Systemspannung 206 bezeichnet. Aufgrund der Parallelschaltung kann der Systemstrom 204 auch als Gesamtstrom des TES-Systems 100 bezeichnet werden.

Ein von der Systemsteuerung 140 gesteuertes Systemschaltschütz 164 ermöglicht, die Systemhochvoltschnittstelle 162 spannungsfrei zu schalten. Alternativ kann das Systemschaltschütz 164 in einer Hochvoltverteilungseinheit des Leistungsnetzes 160 angeordnet sein. In diesem Fall kann das Systemschaltschütz 164 direkt (beispielsweise über den externen Datenbus 132) oder mittelbar (beispielsweise über eine Komponente des Funktionsnetzes 150) von der Systemsteuerung 140 gesteuert werden.

Die erste Datenschnittstelle 142 ist an einen seriellen Bus 202 des Fahrzeugfunktionsnetzes 150, beispielsweise einen vom TES-System 100 unabhängigen CAN-Bus, angeschlossen.

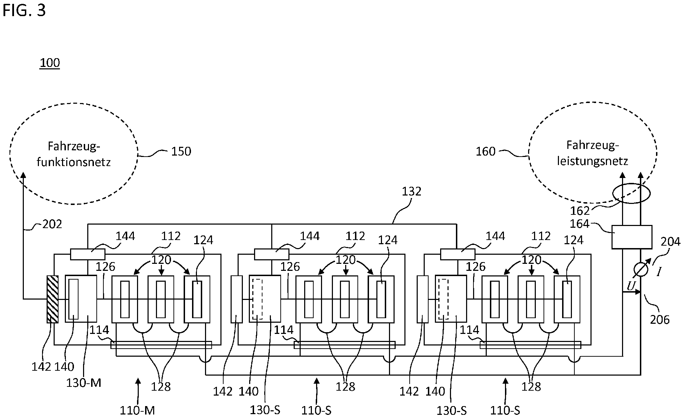

Figur 3 zeigt ein schematisches Blockschaltbild eines dritten Ausführungsbeispiels eines TES-Systems 100 für ein Fahrzeug. Das dritte Ausführungsbeispiel unterscheidet sich vom zweiten Ausführungsbeispiel dadurch, dass die Funktion der Systemsteuerung 140 in einem TES 110-M der TES 110 ausgeführt wird. Hierzu umfasst der TES 110-M die erste Datenschnittstelle 142. Über eine zweite Datenschnittstelle 144 erhält der TES 110-M die Signale der anderen TES 110-S, die nicht die Funktion der Systemsteuerung 140 ausführen. Die erste Datenschnittstelle 142 und die zweite Datenschnittstelle 144 sind jeweils im TES 110-M mit der TES-Steuerung 130-M verbunden, die die Funktion der Systemsteuerung 140 ausführt.

Alle TES 110-M und 110-S (oder zumindest deren TES-Steuerungen 130-M bzw. 130-S) sind vorzugsweise baugleich. Auch die TES 110-S können eine erste Datenschnittstelle 142 umfassen, die außerhalb des TES 110-S unverbunden ist. Die zweiten Datenschnittstellen 144 aller TES 110-M und 110-S sind über den externen Datenbus 132 verbunden.

In einer bevorzugten Ausgestaltung ist die Funktion der Systemsteuerung 140 auch in jeder TES-Steuerung 130-S der TES 110-S implementiert und nicht zur Ausführung aktiviert (gezeigt als gestrichelter Funktionsblock in Figur 3). Durch Setzen eines oder mehrerer Parameter der TES-Steuerung 130 kann die Funktion der Systemsteuerung 140 wahlweise zur Ausführung aktiviert und deaktiviert werden.

Die in den Figuren 2 und 3 gezeigte Parallelschaltung der drei TES-Hochvoltschnittstellen 114 ist beispielhaft. Abhängig von den Anforderungen des Fahrzeugleistungsnetzes 160 (z. B. hinsichtlich Strom, Spannung, Leistung und/oder Energie) kann eine größere Anzahl an TES 110 und/oder eine andere Verschaltung der TES-Hochvoltschnittstellen 114 eingesetzt werden. Insbesondere können die TES-Hochvoltschnittstellen 114 innerhalb jeweils einer Gruppe von TES 110 in Reihe geschaltet sein, und die Gruppen untereinander parallelgeschaltet sein.

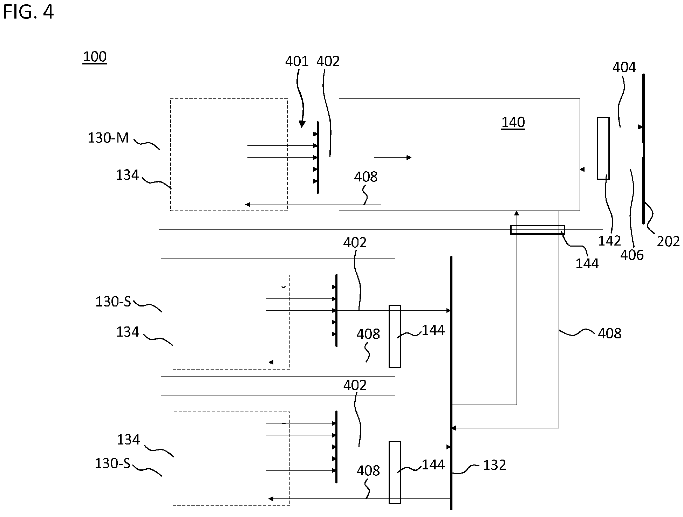

Figur 4 zeigt ein funktionales Blockdiagramm des TES-Systems 100, dessen funktionale Merkmale optional in jedem der vorgenannten Ausführungsbeispiele implementiert sind. Die funktionalen Merkmale können zumindest teilweise durch einen anwendungsspezifischen integrierten Schaltkreis (ASIC) implementiert sein und/oder in einem Speicher kodiert sein, auf den ein Prozessor zur Ausführung der funktionalen Merkmale zugreift.

Die TES-Steuerung 130-M, welche die Funktion der Systemsteuerung 140 ausführt, kann aus einem Slave-Funktionsumfang 134 und dem Funktionsumfang der Systemsteuerung 140 zusammengesetzt sein. Der Slave-Funktionsumfang 134 kann dem Funktionsumfang für den Einzelbetrieb eines einzigen TES und/oder dem Betrieb als Slave-TES 110-S entsprechen. Der Slave-Funktionsumfang 134 kann mit dem (aktiven) Funktionsumfang der anderen TES-Steuerungen 130-S übereinstimmen. Der Slave-Funktionsumfang 134 kann einen bestehenden Funktionsumfang eines herkömmlichen TES beinhalten. Dadurch kann der TES 110 abwärtskompatibel zum Einzelbetrieb sein.

Die Speicherzellen 122 im TES 110-M betreffende Daten 401 (beispielsweise die Messwerte) werden von der TES-Steuerung 130-M in ein Anwendungsformat der Systemsteuerung 140 (beispielsweise als die elektrischen Kenngrößen) multiplexiert und an einer virtuellen oder physischen Schnittstelle als Signal 402 des TES 110-M an die Systemsteuerung 140 übergeben. Entsprechende Daten (beispielsweise die Messwerte) betreffend die Speicherzellen 122 der jeweils anderen TES 110-S werden in den jeweiligen TES-Steuerungen 130-S in das Anwendungsformat der Systemsteuerung 140 (beispielsweise als die elektrischen Kenngrößen) multiplexiert und als das Signal 402 des TES 110-S an der zweiten Datenschnittstelle 144 des jeweiligen TES 110-S mittels des externen Datenbusses 132 an die Systemsteuerung 140 ausgegeben. Auf Grundlage der Signale 402 der TES 110 gibt die Systemsteuerung 140 das Systemsignal 404 an der ersten Datenschnittstelle 142 aus.

In der entgegengesetzten Kommunikationsrichtung kann die Systemsteuerung 140 ein Fahrzeugsignal 406 an der ersten Datenschnittstelle 142 erhalten. Optional verarbeitet die Systemsteuerung 140 das Fahrzeugsignal 406. Die Systemsteuerung 140 leitet (gegebenenfalls nach der Signalverarbeitung) das Fahrzeugsignal 406 selektiv weiter oder gibt ein aus dem Fahrzeugsignal 406 abgeleitetes Steuersignal 408 an den Slave-Funktionsumfang 134 der jeweils betreffenden TES-Steuerungen 130-M und/oder 130-S aus.

Die Konfiguration einer jeden TES-Steuerung 130 als Master-TES-Steuerung 130-M mit aktivierter Funktion der Systemsteuerung 140 oder als Slave-TES-Steuerung 130-S mit deaktivierter Funktion der Systemsteuerung 140 kann dadurch erreicht werden, dass die in allen TES-Steuerungen 130 implementierte Funktion der Systemsteuerung 140 im deaktivierten Zustand eine Weiterleitungsfunktion ausführt. Die Weiterleitungsfunktion leitet die Signale 402 (d. h., die multiplexierten Daten) direkt an die zweite Datenschnittstelle 144 des jeweiligen TES 110-S zur Ausgabe weiter. Die an der zweiten Datenschnittstelle 144 des jeweiligen TES 110-S erhaltenen Steuersignale 408 werden an den Slave-Funktionsumfang 134 der TES-Steuerung 130-S weitergeleitet.

Beispielsweise kann an der ersten Datenschnittstelle 142 ein Notabschaltsignal 406 vom Fahrzeug erhalten werden. In Reaktion auf das erhaltene Notabschaltsignal 406 gibt die Systemsteuerung 140 an das Schaltschütz 170 des eigenen TES 110-M und über den externen Datenbus 132 an alle anderen Schaltschütze 170 ein Steuersignal 408 zur Trennung (d. h. Potenzialfreischaltung) der TES-Hochvoltschnittstellen 114 aus.

Durch die mit der Systemsteuerung 140 verbundene erste Datenschnittstelle 142 ist eine einzige Kommunikationsschnittstelle zum Fahrzeug bereitgestellt, so dass das TES-System 100 hinsichtlich der Kommunikation mit dem Funktionsnetz 150 des Fahrzeugs einem einzigen TES mit entsprechenden Speichereigenschaften gleicht. Vorzugsweise kann durch Konfiguration der Parameter der TES-Steuerung 130 jeder einzelne TES 110 wahlweise als unverbundener Einzel-TES, als Master-TES 110-M im Verbund des TES-Systems 100 oder als Slave-TES 110-S im Verbund des TES-Systems 100 konfiguriert werden.

Die Systemsteuerung 140 gibt mit dem Systemsignal 404 beispielsweise einen aggregierten gemeinsamen Zustand (oder Status) aller zum TES-System 100 gehörenden TES 110 aus. Jedes Signal 402, das von einer der Slave-TES-Steuerungen 130-S ausgegeben wird, wird in der Master-TES-Steuerung 130-M von der Systemsteuerung 140 mit den entsprechenden Signalen 402 (soweit vorhanden) der anderen TES 110 aggregiert und als ein gemeinsamer Wert als das Systemsignal 404 nach außen zum Fahrzeug über die erste Datenschnittstelle 142 kommuniziert.

Die Aggregation beinhaltet auch eine Kontrollfunktion. Beispielsweise umfasst die Kontrollfunktion eine Überprüfung des Verbindungsstatus aller TES 110 am externen Datenbus 132. Alternativ oder ergänzend umfasst die Kontrollfunktion eine Plausibilitätsprüfung der von den Slave-TES-Steuerungen 130-S erhaltenen Signale. Die Plausibilitätsprüfung vergleicht das erhaltene Signal mit für den Signaltyp in der Systemsteuerung 140 gespeicherten Grenzwerten (z. B. Stromgrenzen) für den jeweiligen TES 110-S.

Ist ein erhaltenes Signal fehlerhaft, nicht plausibel oder nicht vorhanden, führt die Systemsteuerung 140 eine Fehlerreaktion aus.

Bestimmen die Daten 402 elektrotechnische Größen (beispielsweise einen momentanen Strom, einen maximal entnehmbaren Strom, eine momentane Spannung oder eine Restladung), berechnet die Systemsteuerung 140 in Abhängigkeit der Verschaltung der TES-Hochvoltschnittstellen 114 die aggregierte elektrotechnische Größe und gibt diese als das Systemsignal aus. Die verwendete Verschaltung der TES-Hochvoltschnittstellen 114 wird im Zuge der Konfiguration des Master-TES 110-S in der Systemsteuerung 140 gespeichert. Beispielsweise sind in der Systemsteuerung 140 in Abhängigkeit von der Verschaltung Aggregationsregeln gespeichert. Die Aggregationsregeln können sowohl für elektrotechnische Kenngrößen (beispielsweise Innenwiderstand, Leerlaufspannung, Ladezustand und/oder Alterungszustand) als auch Grenzwerte definiert sein.

Die Signale 402 der einzelnen TES 110, die eine gemessene Temperatur angeben, werden durch Auffinden eines Extremwerts unter den signalisierten Temperaturwerten aggregiert. Beispielsweise wird unter allen signalisierten Temperaturwerten, die größer als 0°C sind, der größte Temperaturwert im Systemsignal 404 ausgegeben. Alternativ oder ergänzend wird unter allen signalisierten Temperaturwerten, die kleiner oder gleich 0°C sind, der kleinste Temperaturwert im Systemsignal 404 ausgegeben.

Vorzugsweise werden die einzelnen TES 110 durch eine gemeinsame Kühlmittelzirkulation in einem Betriebstemperaturbereich gehalten. Unter den von den einzelnen TES 110 signalisierten Temperaturwerten des Kühlmittels wird der größte Temperaturwert als das Systemsignal ausgegeben.

Die von den einzelnen TES 110 erhaltenen Signale 402 geben optional eine Ladung (z. B. in Coulomb, beispielsweise eine verbleibende Restladung) an. Die Summe der signalisierten Ladungen wird im Systemsignal 404 ausgegeben.

Beispielsweise geben die Signale 402 für jeden verfügbaren TES 110 einen Minimalstrom und/oder Maximalstrom als Grenzwerte des TES 110 an. Ein TES 110 ist verfügbar, wenn von ihm keine Fehlermeldung vorliegt und kein Fehler durch die Systemsteuerung 140 festgestellt wurde.

Dadurch kann sichergestellt werden, dass jeder einzelne TES 110 innerhalb der für seine Eigensicherheit fortlaufend geprüften Betriebsgrenzen betrieben wird. Ferner kann durch den Ausschluss fehlerhafter TES 110 aufgrund der parallelen Verschaltung der TES-Hochvoltschnittstellen 114 mit nur einem Teil der TES 110 das Fahrzeug betrieben werden. Dadurch kann ein redundanter Betrieb (z. B. bei einer Überkapazität an TES 110) oder ein Notbetrieb (z. B. ein sogenannter "Limp Home Mode") realisiert werden.

Fehlerhafte TES 110 werden mittels des jeweiligen Schaltschützes 170 oder der jeweiligen Schaltschütze 170 vom Leistungsnetz 160 getrennt. Jeder einzelne TES 110 implementiert seine Eigensicherheit. Dadurch kann die Systemsteuerung 140 ohne Sicherheitsrelevanz sein.

Optional geben die Signale 402 der einzelnen TES 110 einen Energieinhalt des jeweiligen TES 110 an. Das Systemsignal 404 gibt einen entnehmbaren Gesamtenergieinhalt an. Das Systemsignal 404 kann auf einer (optional gewichteten) Summe der einzelnen Energieinhalte basieren. Der Beitrag der einzelnen Energieinhalte jedes TES 110 zum entnehmbaren Gesamtenergieinhalt kann aus einem anteiligen Batteriestrom bestimmt werden.

Auf Grundlage eines von jedem TES 110 signalisierten Innenwiderstandswerts des jeweiligen TES 110 kann gemäß der Verschaltung der TES-Hochvoltschnittstellen 114 der Gesamtwiderstand des TES-Systems 100 berechnet und als Systemsignal 404 ausgegeben werden. Alternativ oder ergänzend bestimmt die Systemsteuerung 140 auf Grundlage der signalisierten Innenwiderstandswerte den anteiligen Batteriestrom.

Optional erhält die Systemsteuerung 140 von jedem TES 110 Signale 402 mit Lebensdauer-optimierten Grenzwerten (für eine Obergrenze und eine Untergrenze) des Ladezustands. Zur Aggregation der Lebensdauer-optimierten Grenzwerte des Ladezustands wählt die Systemsteuerung 140 die Lebensdauer-optimalen Grenzwerte des Ladezustands aus, welche mit der daraus resultierenden Stromverteilung aller TES 110 möglichst optimal auf eine Soll-Alterungskurve zurückführen. Dabei wird die resultierende Stromverteilung der einzelnen TES 110 aus dem von den einzelnen TES 110 signalisierten Innenwiderstandswerten von der Systemsteuerung 140 berechnet.

Die einzelnen TES 110 können ferner einen Alterungszustand (auch als "State of Health" oder SoH bezeichnet) des jeweiligen TES 110 angeben. Der Alterungszustand der einzelnen TES 110 wird von der Systemsteuerung 140 als Fehlerindikator des jeweiligen TES 110 (z. B. beim Überschreiten von Grenzwerten) und/oder zur Berechnung eines Lebensdauer-optimierten Grenzwerts für den Strom des jeweiligen TES 110 oder des TES-Systems 100 verwendet.

Alternativ oder ergänzend kann der Ladezustand und/oder der Alterungszustand nach denselben Aggregationsregeln berechnet werden, die auch für die Zustandsaggregation der einzelnen Speicherzellen 122 innerhalb der Zellmodulsteuerung 124 implementiert sind.

Die Signale 402 der einzelnen TES 110 geben einen Spannungswert (beispielsweise einen gegenwärtigen und/oder einen vorhergesagten Spannungswert) für die einzelnen TES 110 an. Das Systemsignal 404 für den entsprechenden Spannungswert wird gemäß der Verschaltung der TES-Hochvoltschnittstellen 114 von der Systemsteuerung 140 berechnet. Allgemein kann ein Systemzustand 404 des TES-Systems 100 bestimmt werden, indem der sicherste oder konservativste Zustand aus den von den TES 110 als verfügbar signalisierten Speicherzuständen 402 ausgewählt wird. Alternativ oder ergänzend kann das TES-System 100 gemäß dem leistungsschwächsten TES 110 betrieben wird. Der sicherste Zustand kann der für den momentanen Betrieb aller TES 110 zuverlässigste Zustand sein. Der konservativste Zustand kann eine Lebensdauer aller TES 110 maximieren.

In der Kommunikationsrichtung vom Fahrzeug zu den TES 110 werden alle Fahrzeugsignale 406, welche die Master-TES-Steuerung 110-M vom Fahrzeug erhält, an den jeweiligen Slave-Funktionsumfang 134 der einzelnen TES-Steuerungen 130 verteilt. Gegebenenfalls wird das Fahrzeugsignal dabei in ein für jede einzelne TES-Steuerung 130 spezifisches Steuersignal 408 umgesetzt.

Die Aggregation und Verteilung der Signale durch die Systemsteuerung 140 betrifft auch die Diagnose des TES-Systems 100 (z. B. Diagnoseanforderungen vom Fahrzeug an die Systemsteuerung 140 und Diagnosemeldungen von der Systemsteuerung 140 an das Fahrzeug). Diagnosemeldungen der einzelnen TES-Steuerungen 130 werden durch die Systemsteuerung 140 gesammelt und aggregiert an das Fahrzeug über die erste Datenschnittstelle 142 ausgegeben. Die Aggregation kann beispielsweise die Bildung eines einheitlichen Datensatzes in einem Datenpaket des Systemsignals 404 umfassen. Im Datensatz sind Diagnosewerte bezüglich der einzelnen Zellmodule 120 ohne eine Gruppierung in TES 110 aufgelistet.

Diagnoseabfragen (die auch als Diagnoseroutinen bezeichnet werden) vom Fahrzeug werden an der ersten Datenschnittstelle 142 der Systemsteuerung 140 erhalten und an den bestehenden Funktionsumfang 134 der einzelnen TES-Steuerungen 130 weitergeleitet.

Im Betriebszustand des TES-Systems 100 sind das Systemschaltschütz 164 und die (beispielsweise an den TES-Hochvoltschnittstellen 114 implementierten) Schaltschütze 170 geschlossen. Im Betriebszustand fließen Lade- und Entladeströme durch die Systemhochvoltschnittstelle 162 zu beziehungsweise von den TES 110. Im Betriebszustand sind die Spannungen an den TES-Hochvoltschnittstellen 114 aufgrund der Parallelschaltung der TES 110 einheitlich. Jedoch verteilt sich der durch die Systemhochvoltschnittstelle 162 fließende Strom nicht zu gleichen Teilen auf die TES-Hochvoltschnittstellen 114 der einzelnen TES 110, da sich die TES 110 in ihren elektrischen und/oder elektrochemischen Speicherzuständen unterscheiden.

Die Speicherkapazität jedes TES 110 beschreibt seine Speicherfähigkeit als die im vollständig geladenen Zustand entnehmbare Ladung (z. B. das Zeitintegral des Entladestroms von Anfangsspannung bis Schlussspannung). Der Ladezustand jedes TES 110 ist der Anteil der noch entnehmbaren Ladung an der Speicherkapazität. Der funktionale Zusammenhang zwischen der (z. B. relaxierten) Leerlaufspannung an der TES-Hochvoltschnittstelle 114 und dem Ladezustand des TES 110 ist die Entladekurve. Zum elektrischen Speicherzustand jedes TES 110 gehört ferner die Leerlaufspannung, sein Innenwiderstand, eine erste Zeitkonstante (beispielsweise verursacht durch eine elektrochemische Doppelschicht zwischen Elektrode und Elektrolyt) und/oder eine zweite Zeitkonstante (beispielsweise verursacht durch Diffusion der Ionen im Elektrolyt). Die erste Zeitkonstante kann ein Sekundenbruchteil, beispielsweise weniger als 0,1 s oder 0,01 s sein. Die zweite Zeitkonstante kann größer als die erste Zeitkonstante sein, beispielsweise größer als 1 s oder 10 s.

Mittels einer in der TES-Steuerung 130 gespeicherten Entladekurve kann aufgrund der gemessenen Leerlaufspannung der momentane Ladezustand bestimmt werden. Die Entladekurve kann tabellierten Werten entsprechen und/oder durch Integration des Stroms im Betriebszustand aktualisiert werden.

Die einzelnen TES 110 im TES-System 100 unterscheiden sich in ihren Speicherzuständen, beispielsweise hinsichtlich Speicherkapazität, Entladekurve, Ladezustand, Leerlaufspannung, Innenwiderstand, erster Zeitkonstanten und/oder zweiten Zeitkonstanten. Ursache und lokale Einflussfaktoren der abweichenden Speicherzustände der einzelnen TES 110 sind beispielsweise Fertigungsstreuung, Alterung und Temperatur.

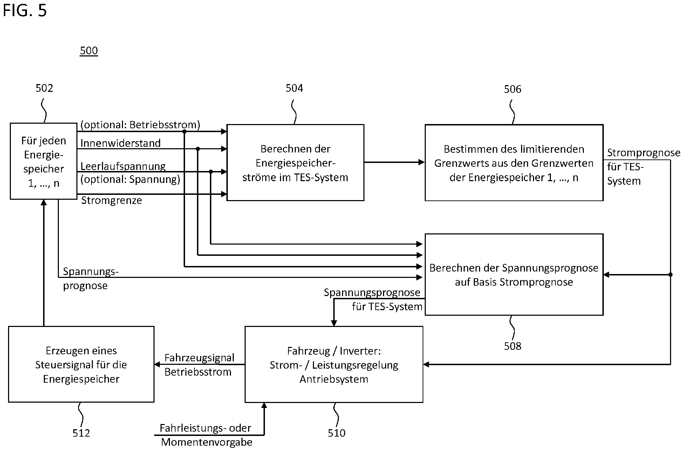

Figur 5 zeigt ein Flussdiagramm einer beispielhaften Implementierung eines Verfahrens 500 zur Bestimmung von Betriebsgrenzen. Die Betriebsgrenzen können einen Systemgrenzwert für die Summe der Ströme in einem TES-System 100 (gemäß jedem vorstehenden Ausführungsbeispiel) umfassen.

In einem Schritt 502 des Verfahrens 500 liest die Systemsteuerung 140 die Signale von den TES-Steuerungen 130 (beispielsweise vom Slave-Funktionsumfang 134) aller TES 110 ein. In einem Ausführungsbeispiel werden für jeden TES 110 ein Innenwiderstand $R_j$ und eine Leerlaufspannung $OCV_j$ als Kenngrößen sowie mindestens eine Stromgrenze (beispielsweise eine obere Stromgrenze $I_j^{max}$) als Grenzwert von der jeweiligen TES-Steuerung 130 an die Systemsteuerung 140 signalisiert, beispielsweise über die zweiten Datenschnittstellen 144 als die Signale 402.

Die Signale 402 können die Kenngrößen jeweils für das Laden des jeweiligen TES 110 und für das Entladen des jeweiligen TES 110 umfassen. Alternativ oder ergänzend erhält die Systemsteuerung 140 von den TES-Steuerungen 130 die Grenzwerte jeweils für das Laden und das Entladen des jeweiligen TES 110.

Der mindestens eine Grenzwert kann auf einen Prognosezeitraum bezogen sein und/oder explizit zeitabhängig sein. Beispielsweise können die Grenzwerte eine obere Stromgrenze $I_j^{max}(t)$, optional differenziert für das Laden und das Entladen, des TES 110 mit Index $j$ für den Zeitpunkt $t$ oder den Prognosezeitraum mit Anfangszeit $t$ umfassen. Alternativ oder ergänzend umfassen die Grenzwerte eine entsprechende untere Stromgrenze $I_j^{min}(t)$ und/oder prognostizierte Grenzwerte für die Spannung des jeweiligen TES 110.

In einem Schritt 504 des Verfahrens 500 berechnet die Systemsteuerung 140 die Ströme $I_j$ der TES 110 mit dem Index $j = 1, ..., n$ im TES-System 100. Vorzugsweise werden die Ströme $I_j$ als Funktion $I_j(U)$ der mit dem Symbol $U$ bezeichneten Systemspannung 206 berechnet. Dabei sind der Innenwiderstand $R_j$ und die Leerlaufspannung $OCV_j$ Parameter der Funktion $I_j(U)$. Alternativ oder ergänzend, beispielsweise auf Grundlage der Funktion $I_j(U)$, werden die Ströme $I_j$ als Funktion $I_j(I)$ des mit dem Symbol $I$ bezeichneten Systemstroms 204 berechnet.

Alternativ oder ergänzend umfassen die im Schritt 502 erhaltenen Kenngrößen einen gegenwärtigen Betriebsstrom $I_j$ und eine gegenwärtigen Klemmenspannung $U$ des $j$-ten TES 110. Basierend auf dem Betriebsstrom $I_j$ und der Klemmenspannung $U$ berechnet die Systemsteuerung 140 im Schritt 504 in Verbindung mit dem jeweiligen Innenwiderstand $R_j$ die Ströme $I_j$. Beispielsweise wird dazu auf Grundlage des gegenwärtigen Betriebsstroms $I_j$ und der gegenwärtigen Klemmenspannung $U$ unter Verwendung des Innenwiderstands $R_j$ die Leerlaufspannung $OCV_j$ des jeweiligen TES 110 berechnet.

Beispielsweise wird im Schritt 504 der jeweilige anteilige Strom $I_j$ des $j$-ten TES 110 gemäß

$$I_j = (OCV_j - U) / R_j \text{ für } j = 1, ..., n \tag{1}$$

berechnet, wobei $U$ die Systemspannung 206, $R_j$ der Innenwiderstand und $OCV_j$ die Leerlaufspannung des $j$-ten TES 110 ist.

Systemgrenzwerte, die zeitabhängig sind und/oder einen Bezug zu einem zukünftigen Prognosezeitraum haben, werden auch als Prognose (beispielsweise Stromprognose oder Spannungsprognose) bezeichnet.

In einem Schritt 506 des Verfahrens 500 werden zumindest ein oberer Systemgrenzwert, $I_{max}$, für den Systemstrom 204 des TES-Systems 100 durch dessen Systemhochvoltschnittstelle 162 und optional ein unterer Systemgrenzwert, $I_{min}$, für den Systemstrom 204 des TES-Systems 100 bestimmt.

Der oder die Systemgrenzwerte des Systemstroms werden aus der Parallelschaltung der TES 110 (bzw. deren TES-Hochvoltschnittstellen 114) bestimmt. Für den oberen Systemgrenzwert des Systemstrom 204 darf der Beitrag $I_j$ jedes TES 110 zum Systemstrom $I$ nicht größer sein oder innerhalb des Prognosezeitraums nie größer werden als die obere Stromgrenze $I_j^{max}$ des jeweiligen TES 110 (bzw. als die kleinste Stromgrenze im Fall mehrerer Stromobergrenzen für den *j*-ten TES 110).

Vorzugsweise wird der obere Systemgrenzwert $I_{max}$ für den Systemstrom 204 berechnet aus den *n* Ungleichungen

$$I_j \le I_j^{\text{max}}, \text{ für } j = 1, \dots, n, \tag{2}$$

wobei der Systemstrom 204 die Summe der Ströme,

$$I = \Sigma_{j=1\dots n} I_j,$$

ist.

Der untere Systemgrenzwert $I_{min}$ für den Systemstrom 204 des TES-Systems 100 kann bestimmt werden aus der Bedingung, dass beim entladenden Betriebsmodus (*I*>0) des TES-Systems 100 keiner der TES 110 einen Ladestrom erhält ($I_j > 0$ für alle *j*), oder aus einem erhaltenen Grenzwert, $I_j^{\text{Laden}}$, für das Laden des jeweiligen TES 110 ($I_j > -I_j^{\text{Laden}}$ für alle *j*). Umgekehrt kann im ladenden Betriebsmodus des TES-Systems 100 der untere Grenzwert, $I_{min}$, für den Systemstrom 204 des TES-Systems 100 aus der Bedingung, dass keiner der TES 110 entladen wird, oder aus einem Grenzwert, $I_j^{\text{Entladen}}$, für das Entladen bestimmt werden.

Sämtliche Systemgrenzwerte können jeweils zeitabhängig und/oder differenziert für das Laden und Entladen bestimmt werden.

Der obere Systemgrenzwert $I_{\text{max}}$, und gegebenenfalls der untere Systemgrenzwert $I_{\text{min}}$, wird als Systemsignal 404 von der Systemsteuerung 140 über die Schnittstelle 202 zum Funktionsnetz 150 des Fahrzeugs ausgegeben, beispielsweise zu einer Leistungsregelung des Antriebs des Fahrzeugs.

Der obere Systemgrenzwert $I_{\text{max}}$, und gegebenenfalls der untere Systemgrenzwert $I_{\text{min}}$, für den Systemstrom 204 des TES-Systems 100 wird auch zur Bestimmung eines oder mehrerer Systemgrenzwerte für die Systemspannung 206 des TES-Systems 100 ausgegeben.

Eine Spannungsprognose wird im Schritt 508 des Verfahrens 500 bestimmt. Beispielsweise wird analog zum Vorgehen im Schritt 506 ein oder mehrere Systemgrenzwerte für die Systemspannung 206 des TES-Systems 100 an der Systemhochvoltschnittstelle 162 zeitabhängig und jeweils für das Laden und Entladen des TES-Systems 100 bestimmt. Diese Systemgrenzwerte für die Systemspannung 206 werden aus den jeweils zur Zeit *t* und dem Betriebsmodus (Laden oder Entladen) bestimmten Systemgrenzwert des Systemstroms 204 in Verbindung mit den Kenngrößen der TES 110 und prognostizierten Grenzwerten für die Spannung der TES 110 (Spannungsprognosen der TES 110) bestimmt.

Die Berechnung der Systemgrenzwerte für den Systemstrom 204 im Schritt 506 und für die Systemspannung 206 im Schritt 508 berücksichtigt auch Ausgleichsströme, $I_{\text{int}}$, innerhalb des TES-Systems 100.

In einem Schritt 510 wird aufgrund einer fahrzeugseitigen Vorgabe der Fahrleistung oder des Antriebsmoments (beispielsweise durch das Gaspedal und/oder ein Fahrerassistenzsystem) unter Berücksichtigung der Systemgrenzwerte für den Systemstrom 204 und die Systemspannung 206 ein Fahrzeugsignal 406 erzeugt und an die Systemsteuerung 140 ausgegeben. Das Fahrzeugsignal 406 gibt den angeforderten Betriebsstrom des Fahrzeugs vor, d. h. ist eine Führungsgröße für den Systemstrom 204 des TES-Systems 100.

In einem Schritt 512 erzeugt die Systemsteuerung 140 aufgrund des Fahrzeugsignals 406 für jedes zur Parallelschaltung gehörende TES 110 ein spezifisches Steuersignal 408. Das Steuersignal 408 kann den Betriebsstrom $I_j$ des jeweiligen TES 110 angeben. Der Betriebsstrom $I_j$ kann unter Verwendung der Funktion $I_j(I)$ mit dem durch das Fahrzeugsignal 406 vorgegebenen Strom *I* berechnet werden.

Die Erzeugung der Signale 402 für den Schritt 502 kann im jeweiligen TES 110, beispielsweise der jeweiligen TES-Steuerung 130, implementiert sein. Zumindest die Schritte 504 bis 508 und 512 können in der Systemsteuerung 140 implementiert sein. Der Schritt 510 kann fahrzeugseitig implementiert sein.

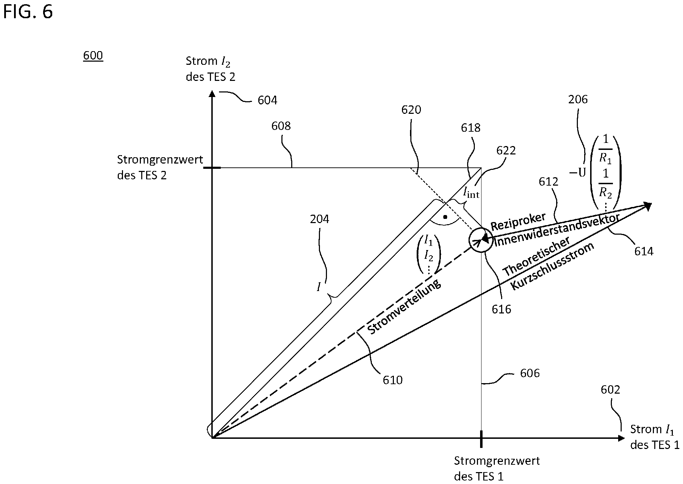

Figur 6 zeigt schematisch ein Diagramm 600 der Ströme im TES-System 100. Zur Übersichtlichkeit sind in Figur 6 nur die Teilströme 602 und 604 zweier beispielhafter TES 110 mit den

Symbolen $I_j$ für *j*=1 bzw. *j*=2 gezeigt. Allgemein wird ein Vektorraum der Ströme im TES-System 100 von *n* orthogonalen Achsen aufgespannt, auf denen die Ströme $I_j$ der TES 110 mit Index *j* = 1, ..., *n* abgetragen sind.

Die Systemsteuerung 140 erhält im Schritt 502 von jedem TES 110 einen Grenzwert 606 bzw. 608 für den jeweiligen Teilstrom 602 bzw. 604.

Die im Schritt 504 berechnete Stromverteilung 610 ist ein Vektor im Diagramm 600 mit Komponenten $I_j$ für *j* = 1, ..., *n,* gemäß dem Gleichungssystem (1). Die Stromverteilung 610 setzt sich zusammen aus einem Stromanteil 612, der gleich dem mit der Systemspannung 206 des TES-Systems, *U,* skalierten reziproken Innenwiderstandsvektor $1/R_j$ ist,

$$- U / R_j \text{ für } j = 1, \ldots, n,$$

und einem (theoretischen) Kurzschlussstrom 614,

$$OCV_j / R_j \text{ für } j = 1, \ldots, n,$$

der fließen würde, wenn der $j$-te TES 110 kurzgeschlossen wäre.

Die Bedingung (2) wird erfüllt, indem der Spannungsabfall $U$ am Fahrzeug (beispielsweise am Gleichspannungseingang des Inverters) so groß ist, dass der Zustand 616 der Stromverteilung 610 am Rand oder innerhalb des durch die Grenzwerte 606 und 608 bestimmten Rechtecks (allgemein: $n$-dimensionaler Rechtkant) liegt.

Der in Figur 6 gezeigte Zustand 616 liegt auf dem Rand des zulässigen Bereichs, der durch den Grenzwert 606 des ersten TES 110 bestimmt ist. D. h. der Grenzwert $I_j^{max}$ für $j = 1$ ist der limitierende Grenzwert, welcher den oberen Systemgrenzwert für den Systemstrom 204 im Schritt 506 bestimmt.

Der in Figur 6 gezeigte Zustand 616 entspricht einer minimalen Systemspannung $U$, d. h. die kleinste zulässige Systemspannung 206 für die erhaltenen Kenngrößen 612 und 614.

Der Systemstrom 204 ist bis auf einen Faktor (nämlich der Quadratwurzel aus der Anzahl, $n$, der parallelgeschalteten TES 110) gleich der Projektion des Vektors, $(I_j)_{j=1..n}$, der Stromverteilung 610 auf die Winkelhalbierende 618 (die nicht notwendigerweise die Diagonale des Rechtecks der Grenzwerte 606, 608 sein muss). Der zur Winkelhalbierenden 618 senkrechte Anteil des Vektors der Stromverteilung 610 in der Ebene 620 entspricht den Ausgleichsströmen 622 innerhalb des TES-Systems 100.

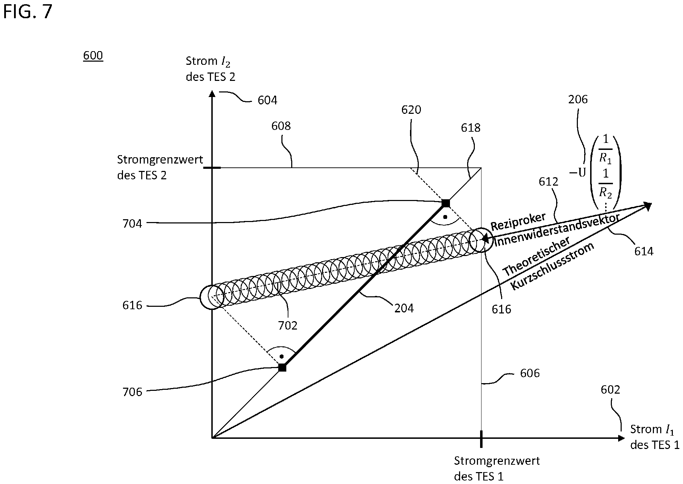

Figur 7 zeigt schematisch im Diagramm 600 die zulässigen und für die erhaltenen Kenngrößen 612 und 614 möglichen Zustände 616 auf einer Linie 702. Größere Systemspannungen 206 als beim in Figur 6 gezeigten Zustand 616 entsprechen kleineren Systemströmen 204 mit einem Stromverteilungsvektor 610, dessen Endpunkt (d. h. Zustand 616) innerhalb des durch die Bedingung (2) definierten Rechtecks auf der Linie 702 in Verlängerung des reziproken Innenwiderstandsvektors 612 liegt.

Der obere Systemgrenzwert, $I_{max}$, für den Systemstrom 204 ist in Figur 7 beim Bezugszeichen 704 dargestellt. Die unteren Grenzwerte, $I_j^{min}$, für den Strom $I_j$ des $j$-ten TES 110 (die in Figur 7 beispielhaft für $I_j^{min} = 0$ dargestellt sind) bestimmen den beim Bezugszeichen 706 gezeigten unteren Systemgrenzwert, $I_{min}$, für den Systemstrom 204. Im in Figur 7 gezeigten Beispiel ist der untere Grenzwerte $I_1^{min}$ limitierend. Der (im Diagramm 600 in Figur 7 am linken Rand liegende) Zustand 616 kleinsten Systemstroms 204 entspricht der größten zulässigen Systemspannung 206.

Obwohl die Erfindung in Bezug auf exemplarische Ausführungsbeispiel beschrieben worden ist, ist es für einen Fachmann ersichtlich, dass verschiedene Änderungen vorgenommen werden können und Äquivalente als Ersatz verwendet werden können. Ferner können viele Modifikationen vorgenommen werden, um eine bestimmte Situation oder ein bestimmtes Material an die Lehre der Erfindung anzupassen. Folglich ist die Erfindung nicht auf die offenbarten Ausführungsbeispiele beschränkt, sondern umfasst alle Ausführungsbeispiele, die in den Bereich der beigefügten Patentansprüche fallen.

**Bezugszeichenliste**

| | |
|---|---|
| 100 | Traktionsenergiespeichersystem |
| 110 | Energiespeicher |
| 112 | Gehäuse des Energiespeichers |
| 114 | Hochvoltschnittstelle |
| 120 | Zellmodul |
| 122 | Speicherzellen |
| 124 | Zellmodulsteuerung |
| 126 | Interner Datenbus |
| 127 | Anschlussklemme |
| 128 | Stromschiene |
| 130 | TES-Steuerung |
| 132 | Externer Datenbus |
| 134 | Funktionsumfang der TES-Steuerung im Einzelbetrieb |
| 140 | Systemsteuerung |

EP 3 323 667 B1

| 142 | Erste Datenschnittstelle |
| 144 | Zweite Datenschnittstelle |
| 150 | Funktionsnetz des Fahrzeugs |
| 160 | Leistungsnetz des Fahrzeugs |
| 162 | Systemhochvoltschnittstelle |
| 164 | Systemschaltschütz |
| 170 | Schaltschütz |
| 172 | Steuerverbindung zwischen TES-Steuerung und Schaltschütz |
| 202 | CAN-Bus des Funktionsnetzes |
| 204 | Systemstrom |
| 206 | Systemspannung |
| 401 | Speicherzellendaten |
| 402 | Signal des Energiespeichers |
| 404 | Systemsignal |
| 406 | Fahrzeugsignal |
| 408 | Steuersignal |
| 500 | Verfahren zur Betriebsgrenzenbestimmung |
| 502 | Schritt des Erhaltens von Kenngrößen |
| 504 | Schritt des Bestimmens von Energiespeicherströmen |
| 506 | Schritt des Bestimmens von Stromgrenzwerten |
| 508 | Schritt des Bestimmens von Spannungsgrenzwerten |
| 510 | Schritt des Erhaltens eines Fahrzeugsignals |
| 512 | Schritt des Erzeugens eines Steuersignals |
| 600 | Diagramm der Ströme |
| 602 | Teilstrom eines ersten Energiespeichers |
| 604 | Teilstrom eines zweiten Energiespeichers |
| 606 | Grenzwert für Teilstrom des ersten Energiespeichers |
| 608 | Grenzwert für Teilstrom des zweiten Energiespeichers |
| 610 | Vektor der Stromverteilung |
| 612 | Stromanteil aus reziprokem Innenwiderstandsvektor |
| 614 | Kurzschlussstrom |
| 616 | Zustand der Stromverteilung |
| 618 | Winkelhalbierende im Diagramm der Ströme |
| 620 | Ebene der Ausgleichströme |
| 622 | Ausgleichströme |
| 702 | Linie der zulässigen und möglichen Zustände |
| 704 | Oberer Systemgrenzwert für den Systemstrom |
| 706 | Unterer Systemgrenzwert für den Systemstrom |

**Patentansprüche**

1.  Traktionsenergiespeichersystem (100) für ein Fahrzeug, umfassend:

    mehrere elektrische Energiespeicher (110), wobei jeder der Energiespeicher ein oder mehrere über Stromschienen (128) elektrisch verbundene Zellmodule (120), eine mit den Stromschienen verbundene oder verbindbare Energiespeicherhochvoltschnittstelle (114) und eine die Zellmodule steuernde Energiespeichersteuerung (130) umfasst, und jedes der Zellmodule mehrere Speicherzellen (122) und eine Zellmodulsteuerung (124) umfasst, und wobei jede der Zellmodulsteuerungen dazu ausgebildet ist, die Speicherzellen im jeweiligen Zellmodul betreffende Messwerte an die Energiespeichersteuerung auszugeben, und jede der Energiespeichersteuerungen dazu ausgebildet ist, abhängig von den erhaltenen Messwerten Signale (402) mit elektrischen Kenngrößen (612, 614) des jeweiligen Energiespeichers (110) und mindestens einem Grenzwert (606, 608) für einen Strom (602, 604) durch die Energiespeicherhochvoltschnittstelle (114) des jeweiligen Energiespeichers zu erzeugen; und

    eine Systemsteuerung (140), die dazu ausgebildet ist, die Signale (402) und Grenzwerte (606, 608) Z von den Energiespeichersteuerungen (130) zu erhalten,
    **dadurch gekennzeichnet, dass** die Systemsteuerung (140) dazu ausgebildet ist, auf Grundlage der Kenngrößen (612, 614) aller Energiespeicher den Strom (602, 604) durch jede der Energiespeicherhochvoltschnittstellen

**15**

(114) bei Parallelschaltung der Energiespeicherhochvoltschnittstellen (114) zu berechnen, und auf Grundlage der berechneten Ströme und der Grenzwerte (606, 608) für die Ströme (602, 604) einen Systemgrenzwert (704, 706) für die Summe (204) der Ströme unter Berücksichtigung von Ausgleichsströmen (622) innerhalb des Traktionsenergiespeichersystems (100) zu bestimmen und als Systemsignal (404) auszugeben.

2. Traktionsenergiespeichersystem nach Anspruch 1, wobei die Ströme (602, 604) durch die parallelgeschalteten Energiespeicherhochvoltschnittstellen (114) berechnet werden als Funktion der Summe (204) der Ströme.

3. Traktionsenergiespeichersystem nach Anspruch 2, wobei die Systemsteuerung (140) ferner dazu ausgebildet ist, den Systemgrenzwert (704, 706) für die Summe (204) der Ströme zu bestimmen durch Maximieren der Summe der Ströme unter Einhaltung der Grenzwerte (606, 608) aller Energiespeicher (110).

4. Traktionsenergiespeichersystem nach Anspruch 2 oder 3, wobei die Systemsteuerung (140) ferner dazu ausgebildet ist, den Systemgrenzwert (704, 706) für die Summe (204) der Ströme zu bestimmen durch Bestimmen eines begrenzenden Grenzwertes (606) unter den Grenzwerten (606, 608) aller Energiespeicher (110), welcher die Funktion der Summe der Ströme begrenzt.

5. Traktionsenergiespeichersystem nach einem der Ansprüche 1 bis 4, wobei die Systemsteuerung (140) ferner dazu ausgebildet ist, auf Grundlage der berechneten Ströme (602, 604) und der Grenzwerte (606, 608) für die Ströme einen Systemgrenzwert für die Spannung (206) der parallelgeschalteten Energiespeicherhochvoltschnittstellen (114) zu bestimmen und als Systemsignal (404) auszugeben.

6. Traktionsenergiespeichersystem nach Anspruch 5, wobei die Systemsteuerung (140) dazu ausgebildet ist, den Systemgrenzwert für die Spannung (206) auf Basis des Systemgrenzwerts (704, 706) für die Summe (204) der Ströme zu bestimmen.

7. Traktionsenergiespeichersystem nach Anspruch 5 oder 6, wobei die Ströme (602, 604) durch die parallelgeschalteten Energiespeicherhochvoltschnittstellen (114) berechnet werden als Funktion der Spannung (206) der parallelgeschalteten Energiespeicherhochvoltschnittstellen (114), und wobei die Systemsteuerung (140) dazu ausgebildet ist, den Systemgrenzwert für die Spannung zu bestimmen durch Maximieren der Spannung der parallelgeschalteten Energiespeicherhochvoltschnittstellen (114) unter Einhaltung der Grenzwerte (606, 608) aller Energiespeicher (110).

8. Traktionsenergiespeichersystem nach einem der Ansprüche 1 bis 7, wobei die Energiespeicher (110) die Grenzwerte (606, 608) jeweils für ein Laden und für ein Entladen des Energiespeichers (110) erzeugen, und wobei die Systemsteuerung (140) den Systemgrenzwert (704, 706) jeweils für das Laden und für das Entladen des Traktionsenergiespeichersystems (100) bestimmt und ausgibt.

9. Traktionsenergiespeichersystem nach einem der Ansprüche 1 bis 8, wobei die Kenngrößen (612, 614) und/oder die Grenzwerte (606, 608) der Energiespeicher (110) eine Funktion eines Prognosezeitraums sind, und wobei der Systemgrenzwert (704, 706) als Funktion des Prognosezeitraums bestimmt und ausgegeben wird.

10. Traktionsenergiespeichersystem nach Anspruch 9, wobei den Grenzwerten (606, 608) der Energiespeicher (110) und/oder der Berechnung der Systemsteuerung (140)

   a) kontinuierliche Ströme im Prognosezeitraum zugrunde liegen oder
   b) kontinuierliche konstante Ströme im Prognosezeitraum zugrunde liegen.

11. Traktionsenergiespeichersystem nach einem der Ansprüche 1 bis 10, wobei die Kenngrößen (612, 614) des jeweiligen Energiespeichers (110) eine Leerlaufspannung und einen Innenwiderstand des jeweiligen Energiespeichers (110) angeben, oder die Kenngrößen (612, 614) von der Leerlaufspannung und dem Innenwiderstand des jeweiligen Energiespeichers (110) abhängen.

12. Traktionsenergiespeichersystem nach einem der Ansprüche 1 bis 11, wobei die Systemsteuerung (140) ferner dazu ausgebildet ist, ein Fahrzeugsignal (406) zu erhalten, zu analysieren und abhängig von der Analyse ein Steuersignal (408) an mindestens eine der Energiespeichersteuerungen (130) auszugeben.

13. Traktionsenergiespeichersystem nach einem der Ansprüche 1 bis 12, wobei eine der Energiespeichersteuerungen (130) die Funktion der Systemsteuerung (140) ausführt.

**14.** Traktionsenergiespeichersystem nach einem der Ansprüche 1 bis 13, wobei die Funktion der Systemsteuerung (140) in jeder der Energiespeichersteuerungen (130) implementiert ist und in einer der Energiespeichersteuerungen (130) zur Ausführung aktiviert ist.

**15.** Traktionsenergiespeichersystem nach einem der Ansprüche 13 oder 14, wobei jeder der Energiespeicher (110) ferner eine erste Datenschnittstelle (142) und eine zweite Datenschnittstelle (144) umfasst, die jeweils im Energiespeicher (110) mit der Energiespeichersteuerung (130) verbunden ist,
wobei bei den Energiespeichern (110-S), welche nicht die Funktion der Systemsteuerung (140) ausführen, die erste Datenschnittstelle (142) außerhalb des Energiespeichers (110-S) unverbunden ist, und die zweite Datenschnittstelle (144) verbunden ist zur Ausgabe des Signals (402) an die zweite Datenschnittstelle (144) des Energiespeichers (110-M), welcher die Funktion der Systemsteuerung (140) ausführt; und
wobei bei dem Energiespeicher (110-M), welcher die Funktion der Systemsteuerung (140) ausführt, die erste Datenschnittstelle (142) außerhalb des Energiespeichers (110-M) mit dem Fahrzeug verbunden ist zur Ausgabe des Systemsignals (404), und die zweite Datenschnittstelle (144) verbunden ist zum Erhalt der Signale (402) von den zweiten Datenschnittstellen (144) der Energiespeicher (110-S), welche nicht die Funktion der Systemsteuerung (140) ausführen.

**16.** Kraftfahrzeug, insbesondere Nutzfahrzeug, umfassend ein Traktionsenergiespeichersystem nach einem der Ansprüche 1 bis 15.

**Claims**

**1.** Traction energy storage system (100) for a vehicle, comprising:

multiple electrical energy stores (110), wherein each of the energy stores comprises one or more cell modules (120) electrically connected via busbars (128), an energy store high-voltage interface (114) connected or connectable to the busbars and an energy store controller (130) controlling the cell modules, and each of the cell modules comprises multiple storage cells (122) and a cell module controller (124), and wherein each of the cell module controllers is configured to output measured values relating to the storage cells in the respective cell module to the energy store controller, and each of the energy store controllers is configured to take the measured values obtained as a basis for generating signals (402) having electrical characteristic quantities (612, 614) of the respective energy store (110) and at least one limit value (606, 608) for a current (602, 604) through the energy store high-voltage interface (114) of the respective energy store; and
a system controller (140) that is configured to obtain the signals (402) and limit values (606, 608) from the energy store controllers (130), **characterized in that** the system controller (140) is configured to take the characteristic quantities (612, 614) of all the energy stores as a basis for computing the current (602, 604) through each of the energy store high-voltage interfaces (114) when the energy store high-voltage interfaces (114) are connected in parallel, and to take the computed currents and the limit values (606, 608) for the currents (602, 604) as a basis for determining a system limit value (704, 706) for the sum (204) of the currents while taking into consideration equalization currents (622) within the traction energy storage system (100) and to output said system limit value as a system signal (404).

**2.** Traction energy storage system according to Claim 1, wherein the currents (602, 604) through the parallel-connected energy store high-voltage interfaces (114) are computed as a function of the sum (204) of the currents.

**3.** Traction energy storage system according to Claim 2, wherein the system controller (140) is further configured to determine the system limit value (704, 706) for the sum (204) of the currents by maximizing the sum of the currents while observing the limit values (606, 608) of all the energy stores (110).

**4.** Traction energy storage system according to Claim 2 or 3, wherein the system controller (140) is further configured to determine the system limit value (704, 706) for the sum (204) of the currents by determining a limiting limit value (606) among the limit values (606, 608) of all the energy stores (110) that limits the function of the sum of the currents.

**5.** Traction energy storage system according to one of Claims 1 to 4, wherein the system controller (140) is further configured to take the computed currents (602, 604) and the limit values (606, 608) for the currents as a basis for determining a system limit value for the voltage (206) of the parallel-connected energy store high-voltage interfaces (114) and to output said system limit value as a system signal (404).

6. Traction energy storage system according to Claim 5, wherein the system controller (140) is configured to determine the system limit value for the voltage (206) on the basis of the system limit value (704, 706) for the sum (204) of the currents.

7. Traction energy storage system according to Claim 5 or 6, wherein the currents (602, 604) through the parallel-connected energy store high-voltage interfaces (114) are computed as a function of the voltage (206) of the parallel-connected energy store high-voltage interfaces (114), and wherein the system controller (140) is configured to determine the system limit value for the voltage by maximizing the voltage of the parallel-connected energy store high-voltage interfaces (114) while observing the limit values (606, 608) of all the energy stores (110).

8. Traction energy storage system according to one of Claims 1 to 7, wherein the energy stores (110) generate the respective limit values (606, 608) for charging and discharge of the energy store (110), and wherein the system controller (140) determines and outputs the respective system limit value (704, 706) for the charging and discharge of the traction energy storage system (100).

9. Traction energy storage system according to one of Claims 1 to 8, wherein the characteristic quantities (612, 614) and/or the limit values (606, 608) of the energy stores (110) are a function of a forecast period, and wherein the system limit value (704, 706) is determined and output as a function of the forecast period.

10. Traction energy storage system according to Claim 9, wherein the limit values (606, 608) of the energy stores (110) and/or the computation of the system controller (140)

   a) are based on continual currents in the forecast period or
   b) are based on continual constant currents in the forecast period.

11. Traction energy storage system according to one of Claims 1 to 10, wherein the characteristic quantities (612, 614) of the respective energy store (110) indicate an open-circuit voltage and an internal resistance of the respective energy store (110), or the characteristic quantities (612, 614) are dependent on the open-circuit voltage and the internal resistance of the respective energy store (110).

12. Traction energy storage system according to one of Claims 1 to 11, wherein the system controller (140) is further configured to obtain a vehicle signal (406), to analyse said vehicle signal and to take the analysis as a basis for outputting a control signal (408) to at least one of the energy store controllers (130).

13. Traction energy storage system according to one of Claims 1 to 12, wherein one of the energy store controllers (130) carries out the function of the system controller (140).

14. Traction energy storage system according to one of Claims 1 to 13, wherein the function of the system controller (140) is implemented in each of the energy store controllers (130) and, in one of the energy store controllers (130), is activated to be carried out.

15. Traction energy storage system according to either of Claims 13 and 14, wherein each of the energy stores (110) further comprises a first data interface (142) and a second data interface (144), each of which is connected in the energy store (110) to the energy store controller (130),
   wherein in the case of the energy stores (110-S) that do not carry out the function of the system controller (140), the first data interface (142) is unconnected outside the energy store (110-S), and the second data interface (144) is connected to output the signal (402) to the second data interface (144) of the energy store (110-M) that carries out the function of the system controller (140); and
   wherein in the case of the energy store (110-M) that carries out the function of the system controller (140), the first data interface (142) is connected to the vehicle outside the energy store (110-M) to output the system signal (404), and the second data interface (144) is connected to obtain the signals (402) from the second data interfaces (144) of the energy stores (110-S) that do not carry out the function of the system controller (140).

16. Motor vehicle, particularly a commercial vehicle, comprising a traction energy storage system according to one of Claims 1 to 15.

**Revendications**

1. Système d'accumulateurs d'énergie de traction (100) destiné à un véhicule, ledit système comprenant :

 une pluralité d'accumulateurs d'énergie électrique (110), chacun des accumulateurs d'énergie comprenant au moins un module de cellules (120) relié électriquement par des barres conductrices (128), une interface d'accumulateur d'énergie à haute tension (114) reliée ou pouvant être reliée aux barres collectrices et une commande d'accumulateurs d'énergie (130) commandant les modules de cellules, et chacun des modules de cellules comprenant une pluralité de cellules d'accumulateur (122) et une commande de module de cellule (124), et chacune des commandes de module de cellule étant conçue pour délivrer des valeurs de mesure, relatives aux cellules d'accumulateur du module de cellule respectif,
 à la commande d'accumulateurs d'énergie, et chacune des commandes d'accumulateurs d'énergie étant conçue pour générer, en fonction des valeurs de mesure obtenues,
 des signaux (402) avec des paramètres électriques (612, 614) de l'accumulateur d'énergie respectif (110) et avec au moins une valeur limite (606, 608) d'un courant (602, 604) circulant à travers l'interface d'accumulateur d'énergie à haute tension (114) de l'accumulateur d'énergie respectif ; et
 une commande de système (140) qui est conçue pour recevoir les signaux (402) et les valeurs limites (606, 608) des commandes d'accumulateurs d'énergie (130), **caractérisé en ce que** la commande de système (140) est conçue pour calculer le courant (602, 604) circulant à travers chacune des interfaces d'accumulateur d'énergie à haute tension (114) lorsque les interfaces d'accumulateur d'énergie à haute tension (114) sont montées en parallèle et sur la base des paramètres (612, 614) de tous les d'accumulateurs d'énergie et pour déterminer, sur la base des courants calculés et des valeurs limites (606, 608) des courants (602, 604),
 une valeur limite de système (704, 706) de la somme (204) des courants avec prise en compte des courants de compensation (622) à l'intérieur du système d'accumulateurs d'énergie de traction (100) et pour la délivrer en sortie sous la forme d'un signal de système (404) .

2. Système d'accumulateurs d'énergie de traction selon la revendication 1, les courants (602, 604) circulant à travers les interfaces d'accumulateur d'énergie à haute tension (114) montées en parallèles étant calculés en fonction de la somme (204) des courants.

3. Système d'accumulateurs d'énergie de traction selon la revendication 2, la commande de système (140) étant en outre conçue pour déterminer la valeur limite de système (704, 706) de la somme (204) des courants par maximisation de la somme des courants et par respect des valeurs limites (606, 608) de tous les accumulateurs d'énergie (110).

4. Système d'accumulateurs d'énergie de traction selon la revendication 2 ou 3, la commande de système (140) étant en outre conçue pour déterminer la valeur limite de système (704, 706) de la somme (204) des courants par détermination, parmi les valeurs limites (606, 608) de tous les accumulateurs d'énergie (110), d'une valeur limite limitative (606) qui borne la fonction de la somme des courants.

5. Système d'accumulateurs d'énergie de traction selon l'une des revendications 1 à 4, la commande de système (140) étant en outre conçue pour déterminer, sur la base des courants calculés (602, 604) et des valeurs limites (606, 608) des courants, une valeur limite de système de la tension (206) des interfaces d'accumulateur d'énergie à haute tension (114) montée en parallèle et la délivrer en sortie sous la forme d'un signal de système (404).

6. Système d'accumulateurs d'énergie de traction selon la revendication 5, la commande de système (140) étant conçue pour déterminer la valeur limite de système de la tension (206) sur la base de la valeur limite de système (704, 706) de la somme (204) des courants.

7. Système d'accumulateurs d'énergie de traction selon la revendication 5 ou 6, les courants (602, 604) circulant à travers les interfaces d'accumulateur d'énergie à haute tension (114) montées en parallèle étant calculés en fonction de la tension (206) des interfaces d'accumulateur d'énergie à haute tension (114) montées en parallèle et la commande de système (140) étant conçue pour déterminer la valeur limite de système de la tension par maximisation de la tension des interfaces d'accumulateur d'énergie à haute tension (114) montées en parallèles et par respect des valeurs limites (606, 608) de tous les accumulateurs d'énergie (110) .

8. Système d'accumulateurs d'énergie de traction selon l'une des revendications 1 à 7, les accumulateurs d'énergie (110) générant les valeurs limites (606, 608) pour charger et décharger respectivement l'accumulateur d'énergie (110), et la commande de système (140) déterminant et délivrant la valeur limite de système (704, 706) pour charger et décharger respectivement le système d'accumulateurs d'énergie de traction (100).

9. Système d'accumulateurs d'énergie de traction selon l'une des revendications 1 à 8, les paramètres (612, 614) et/ou les valeurs limites (606, 608) des accumulateurs d'énergie (110) étant fonction d'une période de prévision, et la valeur limite de système (704, 706) étant déterminée en fonction de la période de prévision et délivrée en sortie.

10. Système d'accumulateurs d'énergie de traction selon la revendication 9,

a) des courants continus de la période de prévision ou
b) des courants constants continus de la période de prévision

étant à la base des valeurs limites (606, 608) des accumulateurs d'énergie (110) et/ou du calcul de la commande du système (140)

11. Système d'accumulateurs d'énergie de traction selon l'une des revendications 1 à 10, les paramètres (612, 614) de l'accumulateur d'énergie respectif (110) indiquant une tension en circuit ouvert et une résistance interne de l'accumulateur d'énergie respectif (110), ou les paramètres (612, 614) dépendant de la tension en circuit ouvert et de la résistance interne de l'accumulateur d'énergie respectif (110).

12. Système d'accumulateurs d'énergie de traction selon l'une des revendications 1 à 11, la commande de système (140) étant en outre conçue pour recevoir un signal de véhicule (406), pour l'analyser et, en fonction de l'analyse, pour délivrer un signal de commande (408) à l'une au moins des commandes d'accumulateur d'énergie (130).

13. Système d'accumulateurs d'énergie de traction selon l'une des revendications 1 à 12, l'une des commandes d'accumulateur d'énergie (130) remplissant la fonction de commande de système (140).

14. Système d'accumulateurs d'énergie de traction selon l'une des revendications 1 à 13, la fonction de la commande de système (140) étant implémentée dans chacune des commandes d'accumulateur d'énergie (130) et étant activée pour être exécutée dans l'une des commandes d'accumulateur d'énergie (130).

15. Système d'accumulateurs d'énergie de traction selon l'une des revendications 13 et 14, chacun des accumulateurs d'énergie (110) comprenant en outre une première interface de données (142) et une deuxième interface de données (144), lesquelles sont reliées dans l'accumulateur d'énergie (110) à la commande d'accumulateur d'énergie (130), dans le cas des accumulateurs d'énergie (110-S) qui ne remplissent pas la fonction de la commande de système (140), la première interface de données (142) située à l'extérieur de l'accumulateur d'énergie (110-S) n'est pas connectée, et la deuxième interface de données (144) est connectée de manière à ce que le signal (402) soit délivré à la deuxième interface de données (144) de l'accumulateur d'énergie (110-M) qui remplit la fonction de la commande de système (140) ; et
dans le cas de l'accumulateur d'énergie (110-M), qui remplit la fonction de la commande de système (140), la première interface de données (142) située à l'extérieur de l'accumulateur d'énergie (110-M) est connectée au véhicule pour délivrer le signal de système (404), et la deuxième interface de données (144) est connectée de manière à recevoir les signaux (402) des deuxièmes interfaces de données (144) des accumulateurs d'énergie (110-S) qui ne remplissent pas la fonction de la commande de système (140).

16. Véhicule automobile, notamment véhicule utilitaire, comprenant un système d'accumulateurs d'énergie de traction selon l'une des revendications 1 à 15.

FIG. 1

FIG. 2

EP 3 323 667 B1

FIG. 3

100

Fahrzeug-
funktionsnetz        150

Fahrzeug-
leistungsnetz        160

132

144  112  124        144  112  124        144  112  124

202

126  120            126  120            126  120

162
164
204

I
U
206

114                 114                 114

142 140              142 140              142 140
130-M                130-S                130-S
128                  128                  128
110-M                110-S                110-S

23

FIG. 4

FIG. 5

500

502

| Für jeden Energie-speicher 1, ..., n |
| --- |

(optional: Betriebsstrom)
Innenwiderstand
Leerlaufspannung
(optional: Spannung)
Stromgrenze

504

| Berechnen der Energiespeicher-ströme im TES-System |
| --- |

506

| Bestimmen des limitierenden Grenzwerts aus den Grenzwerten der Energiespeicher 1, ..., n |
| --- |

Stromprognose für TES-System

Spannungs-prognose

| Berechnen der Spannungsprognose auf Basis Stromprognose |
| --- |

Spannungprognose für TES-System

508

| Erzeugen eines Steuersignal für die Energiespeicher |
| --- |

Fahrzeugsignal Betriebsstrom

| Fahrzeug / Inverter: Strom- / Leistungsregelung Antriebsystem |
| --- |

512

Fahrleistungs- oder Momentenvorgabe

510

FIG. 6

600

Strom $I_2$
des TES 2

604

620

618

206

608

622

$-U \begin{pmatrix} \dfrac{1}{R_1} \\ \dfrac{1}{R_2} \\ \vdots \end{pmatrix}$

Stromgrenzwert
des TES 2

$I_{int}$

612

204

Reziproker
Innenwiderstandsvektor

614

$\begin{pmatrix} I_1 \\ I_2 \\ \vdots \end{pmatrix}$

Theoretischer
Kurzschlussstrom

$I$

Stromverteilung

616

610

606

602

Strom $I_1$
des TES 1

Stromgrenzwert
des TES 1

FIG. 7

Strom $I_2$
des TES 2

600

604

620

608

618

206

$-U\begin{pmatrix} \frac{1}{R_1} \\ \frac{1}{R_2} \\ \vdots \end{pmatrix}$

612

Stromgrenzwert
des TES 2

704

Reziproker
Innenwiderstandsvektor

614

Theoretischer
Kurzschlussstrom

616

616

204

702

606

706

602

Strom $I_1$
des TES 1

Stromgrenzwert
des TES 1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102010002939 A1
- US 20070080662 A1
- DE 102007038532 A1